# EUROPEAN PATENT APPLICATION

(11) **EP 4 485 537 A1**
(43) Date of publication of application: **01.01.2025**
(21) Application number: 22931080.0
(22) Date of filing: 10.03.2022
(51) Int. Cl.: H01L 27/15, H01L 33/62, H01L 33/48, H01L 33/38

(54) **DISPLAY DEVICE**

(71) Applicant: LG Electronics Inc., Yeongdeungpo-gu Seoul 07336 (KR); LG Display Co., Ltd., Seoul 07336 (KR)
(72) Inventor: HEO, Younho, Seoul 06772 (KR); LEE, Jinhyung, Seoul 06772 (KR)
(74) Representative: Vossius & Partner Patentanwälte Rechtsanwälte mbB
(86) International application number: PCT/KR2022/003333
(87) International publication number: WO 2023/171832

(57) **Abstract**

A display device includes a substrate including a plurality of subpixels, a first assembly wiring on each of the plurality of subpixels, a second assembly wiring on each of the plurality of subpixels, a partition wall having assembly holes on the first assembly wiring and the second assembly wiring, and a semiconductor light emitting device in the assembly holes.

The first assembly wiring may include a first bus line, and a first assembly electrode on the first bus line. A portion of the first bus line may be disposed adjacent to the assembly hole, and a portion of the first assembly electrode may be disposed in the assembly hole.

## Description

### [TECHNICAL FIELD]

Embodiments relate to a display device.

### [BACKGROUND ART]

Large-area displays include liquid crystal displays (LCDs), OLED displays, and micro-LED displays.

Micro-LED displays are displays that use micro-LEDs, which are semiconductor light-emitting devices with a diameter or cross-sectional area of 100 micrometers or less, as display devices.

Micro-LED displays use micro-LEDs, which are semiconductor light-emitting devices, as the display device, and therefore have superior performance in many characteristics, including contrast, response time, color gamut, viewing angle, brightness, resolution, lifetime,

Micro-LED displays, in particular, have the advantage of being able to be separated and combined in a modular fashion, allowing for flexible displays that can be adjusted in size or resolution.

However, large micro-LED displays require millions of micro-LEDs, which presents a technical challenge to quickly and accurately transfer micro-LEDs onto a display panel.

Recently developed transfer technologies include the pick and place process, the laser lift-off method or the self-assembly method.

Among these, the self-assembly method is a method in which semiconductor light-emitting devices self-assemble in a fluid, which is advantageous for realizing an interactive display device.

However, the technology to manufacture displays through self-assembly of micro-LEDs is still under-researched.

In particular, when rapidly transferring millions or more semiconductor light-emitting devices onto a large display in the prior art, there is a technical issue where transfer speed can be improved but transfer error rates can be high, resulting in lower transfer yields.

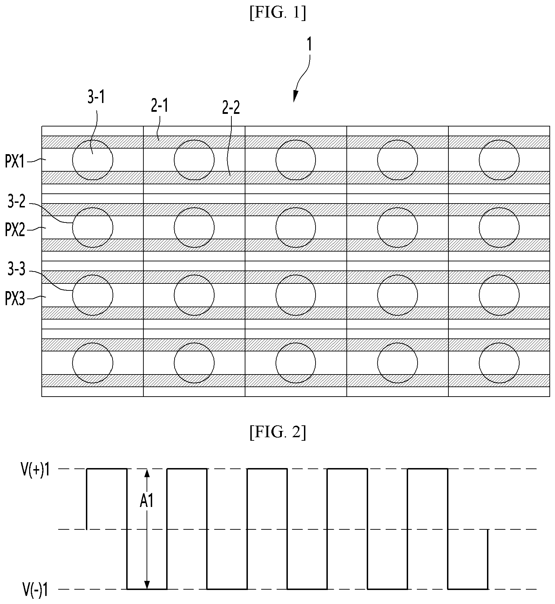

FIG. 1 is a top view illustrating an assembly substrate according to a first undisclosed internal technology.

As shown in FIG. 1, an assembly substrate 1 according to the first non-public internal technology may include a plurality of sub-pixels PX1, PX2, PX3. The plurality of sub-pixel sub-pixels PX1, PX2, PX3 are provided with a first assembly wiring 2-1 and a first assembly wiring 2-2.

A plurality of semiconductor light emitting devices 3-1, 3-2, 3-3 are assembled into a plurality of sub-pixels PX1, PX2, and PX3, respectively, by dielectrophoretic forces formed between the first assembly wiring 2-1 and the first assembly wiring 2-2.

The DEP force is formed on the alternating voltage (V(+)1, V(-)1 in FIG. 2) supplied to the first assembly wiring 2-1 and the second assembly wiring 2-2.

The thinner the thickness or longer the length of each of the first assembly wiring 2-1 and the second assembly wiring 2-2, the greater the line resistance.

As shown in FIG. 1, when the resolution is low, the width of each of the first assembly wiring 2-1 and the first assembly wiring 2-2 is large, and the line resistance is not high, so that no voltage drop or signal delay of the alternating voltage (V(+)1, V(-)1) along the length direction of each of the first assembly wiring 2-1 and the first assembly wiring 2-2 occurs. Accordingly, the DEP force formed between the first assembly wiring 2-1 and the first assembly wiring 2-2 of each sub-pixel PX1, PX2, and PX3 is in accordance with the target value, so that the plurality of semiconductor light emitting devices 3-1, 3-2, 3-3 are well assembled in the sub-pixels PX1, PX2, and PX3, respectively, and no assembly rate degradation problem occurs.

In recent years, there has been a demand for high resolution and high pixel density as well as large surface area. To meet these requirements, more layers and more circuits are required on the assembly substrate, and more pixels (or sub-pixels) are needed in a limited size. As a result, as the size of each pixel shrinks, the width of the circuit lines on each pixel becomes smaller.

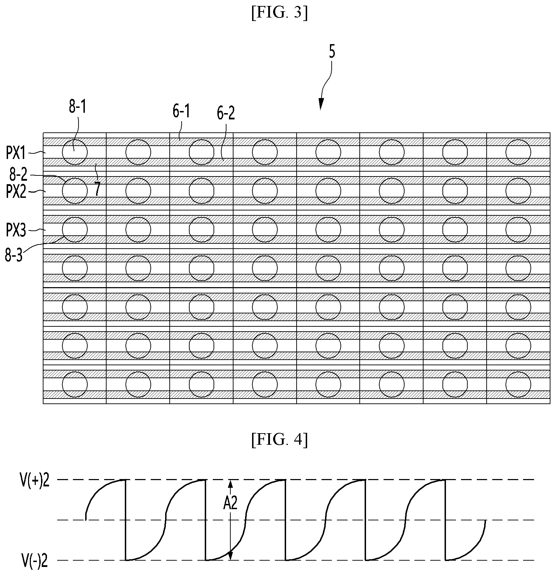

That is, as shown in FIG. 3, the size of each of the plurality of sub-pixels PX1, PX2, PX3 of the assembly substrate 5 according to the second undisclosed technology is smaller than the size of each of the plurality of sub-pixels PX1, PX2, PX3 of the assembly substrate 1 shown in FIG. 1. Accordingly, the line widths of each of the first assembly wiring 6-1 and the second assembly wiring 6-2 provided in each of the plurality of sub-pixels PX1, PX2, and PX3 are also smaller. Accordingly, the line resistance of each of the first assembly wiring 6-1 and the second assembly wiring 6-2 is greatly increased.

When an alternating voltage (V(+)1, V(-)1 in FIG. 2) is applied to the input side of the first assembly wiring 6-1 and the second assembly wiring 6-2 to form a DEP force during self-assembly, due to the large line resistance of each of the first assembly wiring 6-1 and the second assembly wiring 6-2, a voltage drop for the corresponding alternating voltage (V(+)1, V(-)1), resulting in a voltage drop for the corresponding alternating voltages (V(+)2, V(-)2) at each of the plurality of sub-pixels (PX1, PX2, PX3) having signal distortion as shown in FIG. 4. That is, as the amplitude of the alternating voltage decreases from A1 (FIG. 2) to A2 (FIG. 4), the DEP force formed between the first assembly wiring 6-1 and the second assembly wiring 6-2 of each of the plurality of sub-pixels PX1, PX2, and PX3 decreases. As a result, the fixing force for fixing the plurality of semiconductor light-emitting devices 8-1, 8-2, 8-3 in each of the plurality of sub-pixels PX1, PX2, PX3 is weak, resulting in assembly defects and a decrease in the assembly rate.

On the other hand, in order to satisfy the requirements of large area as well as high resolution and high definition, the capacitance is increasing as the assembly substrate is equipped with more layers and more circuits. Accordingly, as the capacitance increases along with an increase in the line resistance of each of the first assembly wiring 6-1 and the second assembly wiring 6-2, signal distortion occurs due to signal delay (or RC delay). Therefore, there is a problem that the amplitude A2 of the alternating voltage (V(+)2, V(-)2) decreases, resulting in a decrease in the assembly rate.

### [DISCLOSURE OF INVENTION]

### [TECHNICAL PROBLEM]

An Embodiments aim to solve the above problems and others.

Another object of the embodiments is to provide a display device having a novel structure.

In addition, it is another object of embodiments to provide a display device having high resolution and high resolution.

It is another object of embodiments to provide a display device having an interactive surface.

It is another object of embodiments to provide a display device that can improve assembly rates.

Technical challenges of the embodiments are not limited to those described herein, but include those that may be appreciated from the description of the invention.

### [TECHNICAL SOLUTION]

To accomplish the above or other purposes, according to one aspect of an embodiment, a display device including: a substrate includes multiple subpixels; a first assembly wiring to each of plurality of subpixels; a second assembly wiring to each of plurality of subpixels; a partition wall having assembly holes on the first assembly wiring and the second assembly wiring; and a semiconductor light emitting device in the assembly hole, the first assembly wiring, a first bus line; and a first assembly electrode; on the first bus line, wherein a portion of the first bus line is disposed adjacent to the assembly hole, a portion of the first assembly electrode is disposed in the assembly hole.

The first assembly wiring may include: a first extending line extending from the first bus line toward the assembly hole; and a first extending electrode extending from the first assembly electrode toward the assembly hole. The first extending line may not overlap perpendicularly with the assembly hole, and the first extending electrode may overlap perpendicularly with the assembly hole.

A width of the first assembly electrode may be greater than the width of the first bus line, the width of the first extending electrode along the first direction may be greater than the width of the first extending line, and the width of the first extending electrode along the second direction may be less than the width of the first extending line.

The second assembly wiring may comprise: a second bus line; and a second assembly electrode on the second bus line, wherein a portion of the second bus line is disposed adjacent to the assembly hole, and a portion of the second assembly electrode is disposed in the assembly hole.

The second assembly wiring may include: a second extending line extending from the second bus line toward the assembly hole; and a second extending electrode extending from the second assembly electrode toward the assembly hole. The second extending line may not overlap perpendicularly with said assembly hole, and the second extending electrode may overlap perpendicularly with the assembly hole.

The width of the second assembly electrode may be greater than the width of the second bus line, the width of the second extending electrode along the first direction may be greater than the width of the second extending line, and the width of the second extending electrode along the second direction may be less than the width of the second extending line.

The first extending electrode may comprise at least two or more electrodes extending from the first assembly electrode. The second extending electrode may comprise at least two or more electrodes extending from the second assembly electrode.

The first extending electrode and the second extending electrode may have a symmetrical structure with respect to each other. The first extending electrode and the second extending electrode may have an asymmetrical structure with respect to each other.

Each of the first bus line and the second bus line may be disposed across the plurality of subpixels, the first assembly electrode may be electrically connected to the first bus line at each of the plurality of subpixels, and the second assembly electrode may be electrically connected to the second bus line at each of the plurality of subpixels.

A thickness of the first assembly electrode may be less than a thickness of the first bus line, and a thickness of the second assembly electrode may be less than a thickness of the second bus line.
a connection electrode connected to a side surface of the semiconductor light emitting device; and electrode wiring connected to a top surface of the semiconductor light emitting device, wherein the connection electrode may be connected to at least one of the first assembly wiring or the second assembly wiring.

### [ADVANTAGEOUS EFFECTS]

According to embodiments, assembly rates can be dramatically improved in display devices with high resolution and/or high resolution.

According to embodiments, assembly rates can be dramatically improved in display devices having a large screen.

According to an embodiment, even if the line width is reduced by a display device having a high-resolution, high-definition, or large screen, by configuring each of the first assembly wiring and/or the second assembly wiring in at least two or more layers, the line resistance of each of the first assembly wiring and/or the second assembly wiring can be reduced to prevent voltage drop or signal distortion of the alternating voltage, thereby improving the assembly rate.

According to embodiments, by ensuring that at least two or more layers including each of the first assembly wiring and/or the second assembly wiring are positioned as close as possible to the assembly hole, even if the line width is reduced by a display device having a high resolution, high-definition, or large screen, the line resistance of each of the first assembly wiring and/or the second assembly wiring can be reduced to prevent voltage drop or signal distortion of the alternating voltage, thereby improving the assembly rate.

According to an embodiment, even if the line width is reduced by a display device having a high-resolution, high-definition, or large screen, by ensuring that a thinner layer of at least two layers including each of the first assembly wiring and/or the second assembly wiring is positioned within the assembly hole, the unevenness of the DEP force during self-assembly can be resolved to prevent poor assembly or decreased assembly rate of the semiconductor light emitting device 150.

Further scope of applicability of the embodiments will become apparent from the following detailed description. However, various changes and modifications within the spirit and scope of the embodiments will be apparent to those skilled in the art, and therefore certain embodiments, such as the detailed description and preferred embodiments, should be understood to be given by way of example only.

### [BRIEF DESCRIPTION OF DRAWINGS]

FIG. 1 is a top view illustrating an assembly substrate according to a first undisclosed internal technology.
FIG. 2 is a view illustrating the alternating voltage supplied to each subpixel for self-assembly on an assembly substrate according to the first undisclosed internal technology.
FIG. 3 is a top view illustrating an assembly substrate according to a second undisclosed internal technology.
FIG. 4 is a view illustrating the alternating voltage supplied to each subpixel for self-assembly on an assembly substrate according to a second undisclosed internal technology.
FIG. 5 is a view illustrating a living room of a house in which a display device according to an embodiment is disposed.
FIG. 6 is a block diagram schematically illustrating a display device according to an embodiment.
FIG. 7 is a schematic illustrating one example of the pixel of FIG. 6.
FIG. 8 is an enlarged view of the first panel area of the display device of FIG. 5.
FIG. 9 is an enlarged view of area A2 in FIG. 8.
FIG. 10 is a diagram illustrating an example of a light emitting device according to an embodiment assembled on a substrate by a self-assembly method.
FIG. 11 is a top view illustrating an assembly substrate according to an embodiment.
FIG. 12A is a plan view illustrating a first bus line and a first extending line including first assembly wiring and a second bus line and a second extending line including second assembly wiring on an assembly substrate according to an embodiment.
FIG. 12B is a plan view illustrating a first assembly electrode and first extending electrode including first assembly wiring and a second assembly electrode and second extending electrode including second assembly wiring on an assembly substrate according to an embodiment.
FIG. 13 is a first embodiment, an enlarged top view of a first sub-pixel of an assembly substrate according to the embodiment of FIG. 11.
FIG. 14 is a cross-sectional view of the first sub-pixel of FIG. 13 cut along lines C1-C2.
FIG. 15 is a cross-sectional view of the first sub-pixel of FIG. 13 cut along lines D1-D2.
FIG. 16 is a second embodiment, an enlarged top view of a first sub-pixel of an assembly substrate according to the embodiment of FIG. 11.
FIG. 17 is a third embodiment, an enlarged top view of a first sub-pixel of an assembly substrate according to the embodiment of FIG. 11.
FIG. 18 is a fourth embodiment, an enlarged top view of a first sub-pixel of an assembly substrate according to the embodiment of FIG. 11.
FIG. 19 is a fifth embodiment, an enlarged top view of a first sub-pixel of an assembly substrate according to the embodiment of FIG. 11.
FIG. 20 is a sixth embodiment, an enlarged top view of a first sub-pixel of an assembly substrate according to the embodiment of FIG. 11.
FIG. 21 is a seventh embodiment, an enlarged top view of a first sub-pixel of an assembly substrate according to the embodiment of FIG. 11.
FIG. 22 is an eighth embodiment, an enlarged plan view of a first sub-pixel of an assembly substrate according to the embodiment of FIG. 11.
FIG. 23 is a ninth embodiment, an enlarged plan view of a first sub-pixel of an assembly substrate according to the embodiment of FIG. 11.
FIG. 24 is a tenth embodiment, an enlarged plan view of a first sub-pixel of an assembly substrate according to the embodiment of FIG. 11.
FIG. 25 is an eleventh embodiment, an enlarged plan view of a first sub-pixel of an assembly substrate according to the embodiment of FIG. 11.
FIG. 26 is a cross-sectional view illustrating a display device according to an embodiment.
FIG. 27 is a cross-sectional view illustrating a semiconductor light emitting device provided in a display device according to an embodiment.

The sizes, shapes, dimensions, etc. of the components shown in the drawings may not be exact. Also, even if the same component is shown in different sizes, shapes, dimensions, etc. in different drawings, this is only an illustrative example, and the same component may have the same size, shape, dimensions, etc. in different drawings.

### [MODE FOR CARRYING OUT THE INVENTION]

Hereinafter, the embodiments disclosed herein will be described in detail with reference to the accompanying drawings, wherein identical or similar components, regardless of drawing designation, are assigned the same reference numerals and duplicate descriptions thereof are omitted. The suffixes "module" and "unit" for components used in the following description are given or used interchangeably for ease of description and are not intended to have a distinct meaning or role by themselves. Further, the accompanying drawings are intended to facilitate understanding of the embodiments disclosed herein, and the technical ideas disclosed herein are not limited by the accompanying drawings. Further, when an element such as a layer, region, or substrate is referred to as being "on" another component, this includes being directly on the other element, or there may be other intermediate elements between them.

Display devices described herein may include televisions, signage, cell phones, smartphones, vehicle head-up displays (HUDs), backlight units for laptop computers, displays for VR or AR, and the like. However, configurations according to the embodiments described herein may be applied to any display-capable device, even in new product forms developed in the future.

Light emitting devices and display devices including the same are described below in accordance with embodiments.

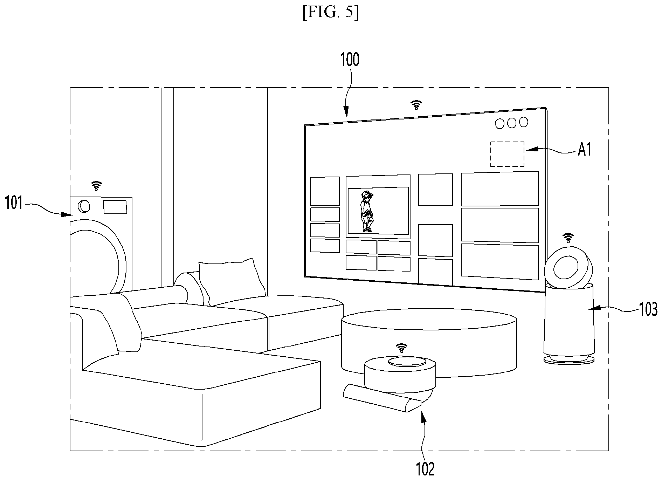

FIG. 5 is a view illustrating a living room of a house in which a display device according to an embodiment is disposed.

Referring to FIG. 5, the display device 100 of the embodiment can display the status of various electronic products, such as a washing machine 101, a robot cleaner 102, an air purifier 103, and the like, and can communicate with each electronic product based on IOT, and can also control each electronic product based on the user's setting data.

The display device 100, according to an embodiment, may include a flexible display fabricated on a thin, flexible substrate. The flexible display can bend and curl like paper, while retaining the characteristics of a traditional flat panel display.

In a flexible display, visual information can be realized by independently controlling the light emission of unit pixels arranged in a matrix. A unit pixel is the smallest unit to represent one color. The unit pixels of the flexible display may be implemented by light emitting devices. In embodiments, the light emitting device may be, but is not limited to, a Micro-LED or a Nano-LED.

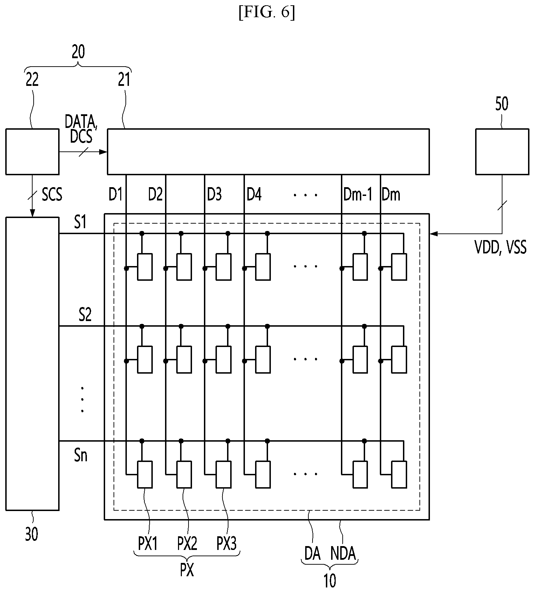

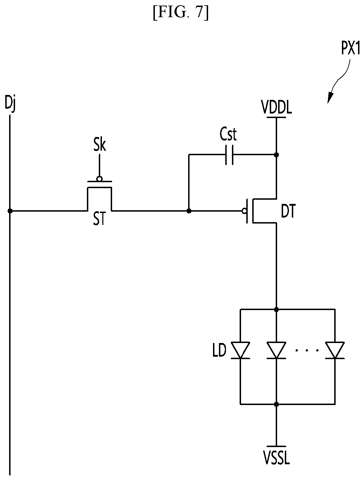

FIG. 6 is a block diagram schematically illustrating a display device according to an embodiment, and FIG. 7 is a schematic illustrating example of the pixel of FIG. 6.

Referring to FIG. 6 and 7, a display device according to an embodiment may include a display panel 10, a drive circuit 20, a scan drive unit 30, and a power supply circuit 50.

The exemplary display device 100 may drive the light emitting devices in an active matrix (AM) or passive matrix (PM) manner.

The drive circuit 20 may include a data drive unit 21 and a timing control unit 22.

The display panel 10 may be rectangular, but is not limited thereto, i.e., the display panel 10 may be formed in a circular or oval shape. At least one side of the display panel 10 may be formed to bend at a predetermined curvature.

The display panel 10 may be divided into a display area (DA) and a non-display area (NDA) arranged around the periphery of the display area (DA). The display area DA is the area where the pixels PX are formed to display the image. The display panel 10 may include data lines (D1~Dm, where m is an integer of 2 or more), scan lines (S1~Sn, where n is an integer of 2 or more) intersecting the data lines (D1~Dm), a high potential voltage line (VDDL) supplied with a high potential voltage, a low potential voltage line (VSSL) supplied with a low potential voltage, and pixels (PX) connected to the data lines (D1~Dm) and the scan lines (S1~Sn).

Each of the pixels (PXs) may include a first sub-pixel (PX1), a second sub-pixel (PX2), and a third sub-pixel (PX3). The first sub-pixel PX1 may emit a first color light of a first dominant wavelength, the second sub-pixel PX2 may emit a second color light of a second dominant wavelength, and the third sub-pixel PX3 may emit a third color light of a third dominant wavelength. The first color light may be red light, the second color light may be green light, and the third color light may be blue light, but is not limited thereto. Also, while FIG. 6 illustrates that each of the pixels PX includes three sub-pixels, it is not limited thereto, i.e., each of the pixels PX may include four or more sub-pixels.

Each of the first sub-pixel PX1, the second sub-pixel PX2, and the third sub-pixel PX3 may be connected to at least one of the data lines D1 to Dm, at least one of the scan lines S1 to Sn, and a high-voltage voltage line VDDL. The first sub-pixel PX1 may include light-emitting devices LD, a plurality of transistors for supplying current to the light-emitting devices LD, and at least one capacitor (Cst), as shown in FIG. 7.

Although not shown, each of the first sub-pixel PX1, the second sub-pixel PX2, and the third sub-pixel PX3 may comprise only one light emitting device LD and at least one capacitor (Cst).

Each of the light emitting devices (LDs) may be a semiconductor light emitting diode including a first electrode, a plurality of conductive semiconductor layers, and a second electrode. Here, the first electrode may be an anode electrode and the second electrode may be a cathode electrode, but is not limited thereto.

The light-emitting device (LD) may be one of a horizontal light-emitting device, a flip-chip light-emitting device, and a vertical light-emitting device.

The plurality of transistors may include a drive transistor DT that supplies current to the light emitting devices LD, and a scan transistor ST that supplies a data voltage to the gate electrode of the drive transistor DT, as shown in FIG. 7. The drive transistor DT may include a gate electrode connected to a source electrode of the scan transistor ST, a source electrode connected to a high potential voltage line (VDDL) to which a high potential voltage is applied, and a drain electrode connected to the first electrodes of the light emitting devices (LDs). The scan transistor ST may include a gate electrode connected to a scan line (Sk, k is an integer satisfying 1≤k≤n), a source electrode connected to a gate electrode of the drive transistor DT, and a drain electrode connected to a data line (Dj, j is an integer satisfying 1≤j≤m).

The capacitor Cst is formed between the gate electrode and the source electrode of the drive transistor DT. The storage capacitor Cst charges the difference between the gate voltage and the source voltage of the drive transistor DT.

The drive transistor DT and the scan transistor ST may be formed as thin film transistors. Furthermore, in FIG. 7, the drive transistor DT and the scan transistor ST are described centering on a P-type MOSFET (Metal Oxide Semiconductor Field Effect Transistor), but the present invention is not limited thereto. The drive transistor DT and the scan transistor ST may also be formed as N-type MOSFETs. In this case, the positions of the source electrode and the drain electrode of the drive transistor DT and the scan transistor ST, respectively, may be changed.

Further, in FIG. 7, it is illustrated that each of the first sub-pixel (PX1), the second sub-pixel (PX2), and the third sub-pixel (PX3) includes a 2T1C (2 Transistor - 1 capacitor) having one drive transistor (DT), one scan transistor (ST), and one capacitor Cst, but the present invention is not limited thereto. Each of the first sub-pixel PX1, the second sub-pixel PX2, and the third sub-pixel PX3 may include a plurality of scan transistors ST and a plurality of capacitors Cst.

Since the second subpixel PX2 and the third subpixel PX3 can be represented by substantially the same schematic as the first subpixel PX1, a detailed description of them is omitted.

The drive circuit 20 outputs signals and voltages to drive the display panel 10. For this purpose, the drive circuit 20 may include a data drive unit 21 and a timing control unit 22.

The data drive unit 21 receives digital video data (DATA) and a source control signal (DCS) from the timing control unit 22. The data drive unit 21 converts the digital video data (DATA) into analog data voltages according to the source control signal (DCS) and supplies them to the data lines (D1~Dm) of the display panel (10).

The timing control unit 22 receives digital video data (DATA) and timing signals from the host system. The timing signals may include a vertical sync signal, a horizontal sync signal, a data enable signal, and a dot clock. The host system may be an application processor in a smartphone or tablet PC, a system-on-chip in a monitor, a TV, etc.

The timing control section 22 generates control signals for controlling the timing of operation of the data drive section 21 and the scan drive section 30. The control signals may include a source control signal (DCS) to control the timing of operation of the data drive 21 and a scan control signal (SCS) to control the timing of operation of the scan drive 30.

The drive circuitry 20 may be disposed in a non-display area (NDA) provided on one side of the display panel 10. The driving circuitry 20 may be formed as an integrated circuit (IC) and mounted on the display panel 10 by a chip on glass (COG) method, a chip on plastic (COP) method, or an ultrasonic bonding method, but the present invention is not limited thereto. For example, the driving circuitry 20 may be mounted on a circuit board (not shown) rather than on the display panel 10.

The data drive 21 may be mounted on the display panel 10 by a COG (chip on glass) method, COP (chip on plastic) method, or ultrasonic bonding method, and the timing control 22 may be mounted on a circuit board.

The scan drive unit 30 receives a scan control signal (SCS) from the timing control unit 22. The scan drive unit 30 generates scan signals according to the scan control signal (SCS) and supplies them to the scan lines S1 through Sn of the display panel 10. The scan driver 30 may be formed in the non-display area (NDA) of the display panel 10, including a plurality of transistors. Alternatively, the scan drive unit 30 may be formed as an integrated circuit, in which case it may be mounted on a gate flexible film that is attached to the other side of the display panel 10.

The circuit board may be attached to pads provided on one edge region of the display panel 10 using an anisotropic conductive film. Thereby, the lead lines of the circuit board may be electrically connected to the pads. The circuit board may be a flexible film, such as a flexible printed circuit board, a printed circuit board, or a chip on film. The circuit board may be bent to a lower portion of the display panel 10. As a result, one side of the circuit board may be attached to a first side edge region of the display panel 10, and the other side may be disposed on the lower portion of the display panel 10 and connected to a system board on which a host system is mounted.

The power supply circuit 50 may generate and supply voltages necessary to drive the display panel 10 from a main power source applied from the system board to the display panel 10. For example, the power supply circuit 50 may generate a high potential voltage (VDD) and a low potential voltage (VSS) to drive the light emitting devices (LDs) of the display panel 10 from the main power source and supply them to a high potential voltage line (VDDL) and a low potential voltage line (VSSL) of the display panel 10. Further, the power supply circuit 50 may generate and supply drive voltages to drive the drive circuit 20 and the scan drive unit 30 from the main power source.

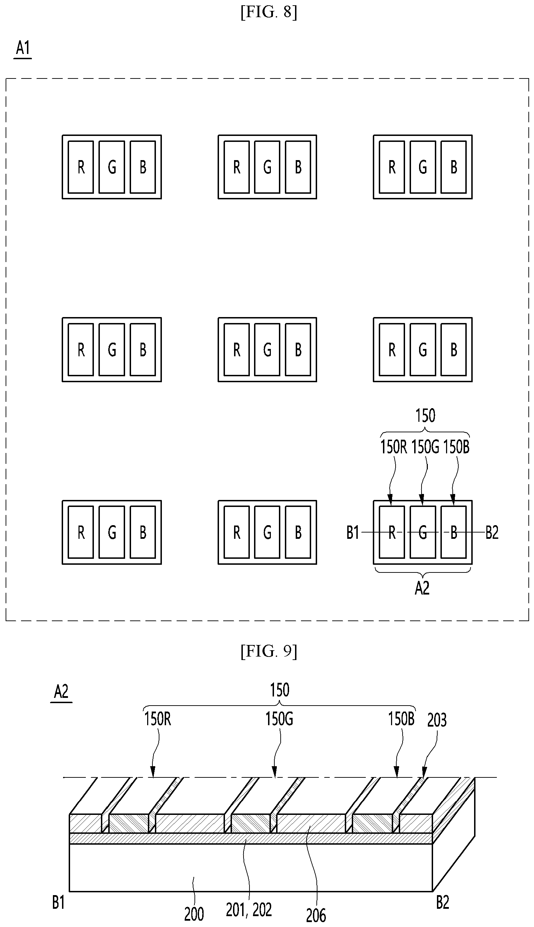

FIG. 8 is a magnified view of the first panel area of the display device of FIG. 3.

Referring to FIG. 8, the exemplary display device 100 may be manufactured in which a plurality of panel areas, such as the first panel area A1, are mechanically and electrically connected by tiling.

The first panel area A1 may include a plurality of semiconductor light emitting devices 150 disposed per unit pixel (PX in FIG. 6).

For example, the unit pixel PX may include a first sub-pixel PX1, a second sub-pixel PX2, and a third sub-pixel PX3. For example, a plurality of first semiconductor light-emitting devices 150R may be disposed in the first sub-pixel PX1, a plurality of second semiconductor light-emitting devices 150G may be disposed in the second sub-pixel PX2, and a plurality of third semiconductor light-emitting devices 150B may be disposed in the third sub-pixel PX3. The unit pixel PX may further include, but is not limited to, a fourth sub-pixel in which no semiconductor light emitting devices are disposed.

FIG. 9 is an enlarged view of area A2 in FIG. 8.

Referring to FIG. 9, the exemplary display device 100 may include a substrate 200, assembly wiring 201, 202, an insulating layer 206, and a plurality of semiconductor light emitting devices 150. More components may be included than these.

The assembly wiring may include a first assembly wiring 201 and a second assembly wiring 202 spaced apart from each other. The first assembly wiring 201 and the second assembly wiring 202 may be configured to generate dielectrophoretic forces to assemble the semiconductor light emitting device 150. For example, the semiconductor light-emitting device 150 may be one of a horizontal semiconductor light-emitting device, a flip-chip semiconductor light-emitting device, and a vertical semiconductor light-emitting device.

The semiconductor light-emitting device 150 may include, but is not limited to, a first semiconductor light-emitting device 150, a second semiconductor light-emitting device 150G, and a third semiconductor light-emitting device 150B0 to form a sub-pixel, respectively, and may be equipped with a red phosphor and a green phosphor or the like to realize red and green colors, respectively.

The substrate 200 may be a support member that supports components disposed on the substrate 200, or it may be a protective member that protects the components.

The substrate 200 may be a rigid substrate or a flexible substrate. The substrate 200 may be formed of sapphire, glass, silicon, or polyimide. The substrate 200 may also include a flexible material such as polyethylene naphthalate (PEN), polyethylene terephthalate (PET), or the like. Additionally, the substrate 200 may be a transparent material, but is not limited thereto. The substrate 200 may function as a support substrate in a display panel, and may also function as an assembly substrate for self-assembly of the light emitting device.

The substrate 200 may be a backplane with circuitry within the sub-pixels PX1, PX2, PX3 shown in FIGS. 6 and 7, such as, but not limited to, transistors ST, DT, capacitors Cst, signal wiring, and the like.

The insulating layer 206 may include an insulating and flexible organic material such as polyimide, PAC, PEN, PET, polymer, or the like, or an inorganic material such as silicon oxide (SiO2) or silicon nitride series (SiNx), or the like, and may be integrally formed with the substrate 200 to form a single substrate.

The insulating layer 206 can be a conductive adhesive layer that is both adhesive and conductive, and the conductive adhesive layer can be flexible to enable flexible functionality of the display device. For example, the insulating layer 206 may be an anisotropy conductive film (ACF) or a conductive adhesive layer, such as an anisotropic conductive medium, a solution containing conductive particles, or the like. The conductive adhesive layer may be electrically conductive in the vertical direction with respect to the thickness, or electrically insulating in the horizontal direction with respect to the thickness.

The insulating layer 206 may include assembly holes 203 for insertion of the semiconductor light emitting device 150. Thus, during self-assembly, the semiconductor light-emitting device 150 can be easily inserted into the assembly holes 203 of the insulating layer 206. The assembly holes 203 may be referred to as insertion holes, fixation holes, alignment holes, and the like. The assembly holes 203 may also be referred to as holes.

The assembly holes 203 may be referred to as holes, furrows, grooves, recesses, pockets, etc.

The assembly hole 203 may vary depending on the shape of the semiconductor light emitting device 150. For example, each of the first semiconductor light-emitting device, the second semiconductor light-emitting device, and the third semiconductor light-emitting device may have a different shape, and each of the semiconductor light-emitting devices may have an assembly hole 203 having a shape corresponding to the shape of each of the semiconductor light-emitting devices. For example, the assembly holes 203 may include a first assembly hole for assembling the first semiconductor light-emitting device, a second assembly hole for assembling the second semiconductor light-emitting device, and a third assembly hole for assembling the third semiconductor light-emitting device. For example, the first semiconductor light-emitting device may have a circular shape, the second semiconductor light-emitting device may have a first elliptical shape having a first short axis and a second long axis, and the third semiconductor light-emitting device may have a second elliptical shape having a second short axis and a second long axis. The second long axis of the ellipse of the third semiconductor light-emitting device may be larger than the second long axis of the ellipse of the second semiconductor light-emitting device, and the second short axis of the ellipse of the third semiconductor light-emitting device may be smaller than the first short axis of the ellipse of the second semiconductor light-emitting device.

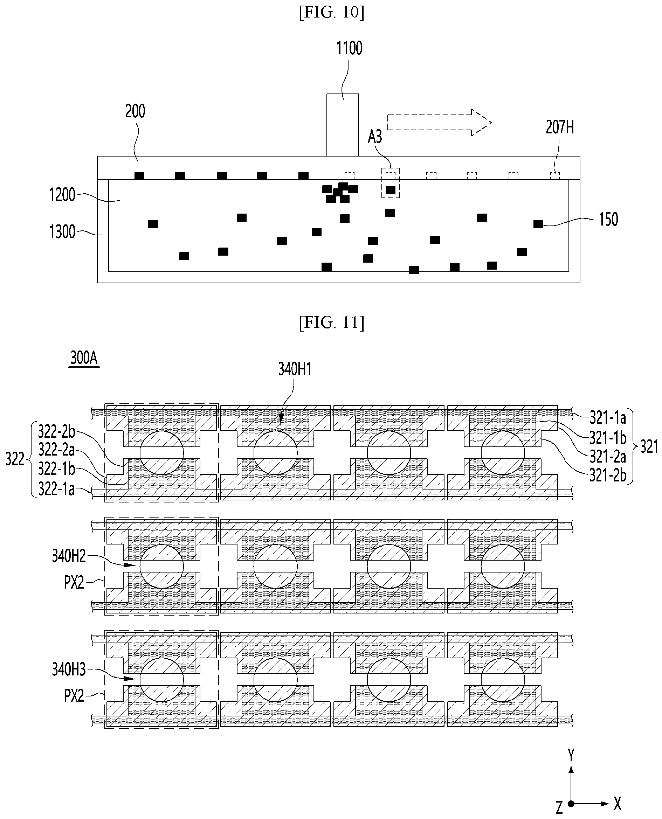

On the other hand, the method of mounting the semiconductor light emitting device 150 on the substrate 200 may include, for example, a self-assembly method (FIG. 10) and a transfer method.

FIG. 10 is a diagram illustrating an example of a light-emitting device according to an embodiment assembled on a substrate by a self-assembly method.

Referring now to FIG. 10, an example will be described in which a semiconductor light-emitting device according to an embodiment is assembled into a display panel by a self-assembly method using an electromagnetic field.

The assembly substrate 200 described hereinafter may also function as a panel board 200a in a display device after assembly of the light emitting devices, but embodiments are not limited thereto.

Referring to FIG. 10, the semiconductor light-emitting devices 150 may be placed in a chamber 1300 filled with fluid 1200, and the semiconductor light-emitting devices 150 may be moved to the assembly substrate 200 by a magnetic field generated by the assembly device 1100. At this time, the light emitting devices 150 adj acent to the assembly holes 207H of the assembly substrate 200 may be assembled in the assembly holes 207H by a DEP force caused by the electric field of the assembly wiring. The fluid 1200 may be, but is not limited to, water, such as ultrapure water. The chamber may be referred to as a bath, container, vessel, or the like.

After the semiconductor light emitting device 150 is loaded into the chamber 1300, the assembly substrate 200 may be disposed on the chamber 1300. In accordance with embodiments, the assembly substrate 200 may be loaded into the chamber 1300.

After the assembly substrate 200 is disposed in the chamber, an assembly device 1100 that applies a magnetic field may be moved along the assembly substrate 200. The assembly device 1100 may be a permanent magnet or an electromagnet.

The assembly device 1100 can be moved into contact with the assembly substrate 200 to maximize the area of the magnetic field into the fluid 1200. In some embodiments, the assembly device 1100 may include a plurality of magnets, or may include magnets of a size corresponding to the assembly substrate 200. In this case, the travel distance of the assembly device 1100 may be limited to within a predetermined range.

A magnetic field generated by the assembly device 1100 may cause the semiconductor light emitting devices 150 in the chamber 1300 to move toward the assembly device 1100 and the assembly substrate 200.

The semiconductor light emitting device 150 may enter and be held in the assembly hole 207H by a DEP force formed by the electric field between the assembly wiring 201, 202 during its movement toward the assembly device 1100.

Specifically, the first and second assembly wirings 201, 202 may be subjected to an alternating current power source to form an electric field, and a DEP force may be formed between the assembly wirings 201, 202 by this electric field. This DEP force can hold the semiconductor light emitting device 150 in the assembly hole 207H on the assembly substrate 200.

At this time, a predetermined solder layer (not shown) may be formed between the light-emitting device 150 assembled on the assembly hole 207H of the assembly substrate 200 and the assembly wiring 201, 202 to improve the bonding force of the light-emitting device 150.

Additionally, a molding layer (not shown) may be formed in the assembly hole 207H of the assembly substrate 200 after assembly. The molding layer may be a transparent resin or a resin containing reflective or scattering materials.

By self-assembling using the electromagnetic field described above, the time required for each semiconductor light-emitting device to be assembled on a substrate can be drastically reduced, allowing large-area, high-pixel displays to be realized more quickly and economically.

Referring now to FIGS. 11 through 27, various embodiments for solving the problems described above will be described. Any description that is omitted herein will be readily understood from the description set forth above with reference to FIGS. 1 through 10 and their respective drawings.

FIG. 11 is a top view illustrating an assembly substrate according to an embodiment.

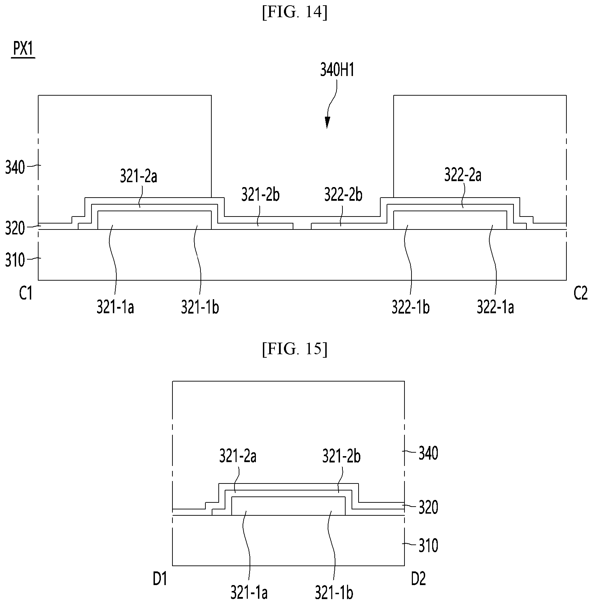

Referring to FIG. 11, the assembly substrate 300A according to an embodiment may include a substrate (310 in FIGs 14 and 15), first assembly wiring 321, and second assembly wiring 322. The assembly substrate 300A according to embodiments may include more components than these.

The line widths of each of the first assembly wiring 321 and second assembly wiring 322 shown in FIG. 11 are larger than the line widths of each of the assembly wiring 2-1, 2-2 shown in FIG. 1 or the line widths of each of the assembly wiring 6-1, 6-2 shown in FIG. 3. However, this is for illustrative purposes only, and the embodiment applies to a high-resolution and high-pixel resolution display device, and in practice, the line widths of each of the first assembly wiring 321 and second assembly wiring 322 shown in FIG. 11 are much smaller than the line widths of each of the assembly wiring 2-1, 2-2 shown in FIG. 1 or the line widths of each of the assembly wiring 6-1, 6-2 shown in FIG. 3.

The substrate 310 may include a plurality of subpixels PX1, PX2, PX3.

The plurality of sub-pixels may include a plurality of first sub-pixels (PX1) arranged along the first direction (X). The plurality of first sub-pixels PX1 may each emit the same color light, i.e., first color light.

For example, the plurality of sub-pixels may include a plurality of second sub-pixels PX2 adjacent along the second direction Y and arranged along the first direction X from each of the plurality of first sub-pixels PX1. The plurality of second sub-pixels PX2 may each emit the same color light, i.e., second color light.

For example, the plurality of sub-pixels may include a plurality of third sub-pixels PX3 adjacent along the second direction Y and arranged along the first direction X in each of the plurality of second sub-pixels PX2. The plurality of third sub-pixels PX3 may emit the same color light, i.e., third color light.

The first color light may be red light, the second color light may be green light, and the third color light may be blue light, but is not limited thereto. The first sub-pixel PX1, the second sub-pixel PX2, and the third sub-pixel PX3 arranged along the second direction Y may constitute a unit pixel capable of displaying a fuller color image. Thus, by having a plurality of unit pixels arranged on the substrate 310, a large area of image may be displayed.

First assembly wiring 321 and second assembly wiring 322 may be disposed on substrate 310.

The first assembly wiring 321 and the second assembly wiring 322 may each be extended along the first direction X, i.e., the first assembly wiring 321 may be extended along the first direction X and the second assembly wiring 322 may be spaced apart from the first assembly wiring 321 and extended along the first direction X. The first assembly wiring 321 and the second assembly wiring 322 may be disposed parallel to each other.

For example, the first assembly wiring 321 and the second assembly wiring 322 may be disposed in a plurality of first sub-pixels PX1 arranged along the first direction X. For example, the first assembly wiring 321 and the second assembly wiring 322 may be disposed in a plurality of second sub-pixels PX2 arranged along the first direction X. For example, the first assembly wiring 321 and the second assembly wiring 322 may be disposed in a plurality of third sub-pixels PX3 arranged along the first direction X.

On the other hand, the plurality of sub-pixels PX1, PX2, PX3 may each include at least one assembly hole 340H1, 340H2, 340H3. For example, each of the plurality of first sub-pixels PX1 arranged along the first direction X may be provided with at least one first assembly hole 340H1. For example, each of the plurality of second sub-pixels (PX2) arranged along the first direction (X) may be provided with at least one second assembly hole (340H2). For example, each of the plurality of third sub-pixels (PX3) arranged along the first direction (X) may be provided with at least one third assembly hole (340H3).

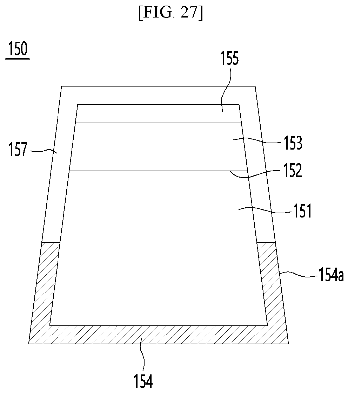

The plurality of assembly holes 340H1, 340H2, 340H3 may each be disposed with a plurality of semiconductor light emitting devices 150 in FIG. 27. For example, each of the plurality of first assembly holes 340H1 arranged along the first direction X may be disposed with a first semiconductor light emitting device 150. In each of the plurality of second assembly holes 340H2 arranged along the first direction X, a second semiconductor light emitting device (not shown) may be disposed, for example. In each of the plurality of third assembly holes 340H3 arranged along the first direction X, a third semiconductor light emitting device (not shown) may be disposed, for example.

The first semiconductor light emitting device 150, the second semiconductor light emitting device, and the third semiconductor light emitting device may generate different colored light. For example, the first semiconductor light emitting device 150 may generate red light, the second semiconductor light emitting device may generate green light, and the third semiconductor light emitting device may generate blue light. A full-color image may be displayed using the red light, green light, and blue light.

In the following, unless otherwise noted, the first semiconductor light-emitting device 150 may refer to a semiconductor light-emitting device for emitting red light disposed in the first assembly hole 340H1 in FIG. 11, the second semiconductor light-emitting device may refer to a semiconductor light-emitting device for emitting green light disposed in the second assembly hole 340H2 in FIG. 11, and the third semiconductor light-emitting device may refer to a semiconductor light-emitting device for emitting blue light disposed in the third assembly hole 340H3 in FIG. 11.

In addition, unless otherwise noted herein, the semiconductor light emitting device may refer to the first semiconductor light emitting device 150.

In an embodiment, the first assembly wiring 321 and the second assembly wiring 322 may each include at least two layers.

The first assembly wiring 321 may include a first bus line 321-1a, a first extending line 321-1b, a first assembly electrode 321-2a, and a first extending electrode 321-2b. For example, the first assembly electrode 321-2a may be disposed on the first bus line 321-1a. For example, the first assembly electrode 321-2a may be vertically overlapped with the first bus line 321-1a. For example, the first extending electrode 321-2b may be disposed on the first extending line 321-1b. For example, the first extending electrode 321-2b may be vertically overlapped with the first extending line 321-1b.

The second assembly wiring 322 may include a second bus line 322-1a, a second extending line 322-1b, a second assembly electrode 322-2a, and a second extending electrode 322-2b. For example, the second assembly electrode 322-2a may be disposed on the second bus line 322-1a. For example, the second assembly electrode 322-2a may be vertically overlapped with the second bus line 322-1a. For example, the second extending electrode 322-2b may be disposed on the second extending line 322-1b. For example, the second extending electrode 322-2b may be vertically overlapped with the second extending line 322-1b.

On the other hand, as previously described, the line widths of each of the first assembly wiring 321 and/or the second assembly wiring 322 are being reduced as higher resolution, higher detail, and larger screens are required. As such, when the line width of each of the first assembly wiring 321 and/or the second assembly wiring 322 is reduced, the line resistance of each of the first assembly wiring 321 and/or the second assembly wiring 322 is increased, causing a voltage drop and/or signal delay (or RC delay) in the alternating voltage delivered to each of the plurality of sub-pixels via each of the first assembly wiring 321 and/or the second assembly wiring 322. Due to the voltage drop and/or signal delay (or RC delay), the assembly rate of the semiconductor light emitting device 150 is significantly reduced during self-assembly.

Increasing the thickness or width of each of the first assembly wiring 321 and/or the second assembly wiring 322 may be considered to reduce line resistance.

When a wet etching process is performed to form the first assembly wiring 321 and/or the second assembly wiring 322, it is very difficult to form a thicker thickness of each of the first assembly wiring 321 and the second assembly wiring 322 while maintaining a predetermined spacing between the first assembly wiring 321 and the second assembly wiring 322 due to isotropic etching. Therefore, it is difficult to consider increasing the thickness of each of the first assembly wiring 321 and the second assembly wiring 322.

Furthermore, a portion of each of the first assembly wiring 321 and/or the second assembly wiring 322 is to be located within the assembly holes 340H1, 340H2, 340H3 so that a DEP force corresponding to the target value is formed within the assembly holes 340H1, 340H2, 340H3 during self-assembly. However, if a portion of each of the thicker first assembly wiring 321 and/or the thicker second assembly wiring 322 is positioned within the assembly holes 340H1, 340H2, 340H3, DEP force becomes uneven and the assembly force of the semiconductor light-emitting device 150 assembled on the substrate 310 during self-assembly is reduced, causing the semiconductor light-emitting device 150 assembled within the assembly holes 340H1, 340H2, 340H3 to fall out of the assembly holes 340H1, 340H2, 340H3, resulting in poor assembly or a reduced assembly rate. Therefore, it is difficult to reduce the line resistance of each of the first assembly wiring 321 and/or the second assembly wiring 322 if each of the first assembly wiring 321 and/or the second assembly wiring 322 is formed as a single layer or has a large thickness.

Embodiments are intended to address the technical challenges described above, and may reduce the line resistance of each of the first assembly wiring 321 and/or the second assembly wiring 322 by configuring each of the first assembly wiring 321 and/or the second assembly wiring 322 with at least two or more layers, or by ensuring that the two or more layers are positioned as close as possible to the assembly holes 340H1, 340H2, 340H3. Furthermore, by positioning the thinner of the two or more layers within the assembly holes 340H1, 340H2, 340H3, the unevenness of the DEP force during self-assembly can be resolved, thereby preventing poor assembly or low assembly rate of the semiconductor light emitting device 150.

A portion of the first assembly wiring 321 and/or a portion of the second assembly wiring 322 may be disposed in the assembly holes 340H1, 340H2, 340H3. For example, a portion of the first assembly wiring 321 and/or a portion of the second assembly wiring 322 may contact the assembly holes 340H1, 340H2, 340H3 or may overlap perpendicularly with the assembly holes 340H1, 340H2, 340H3.

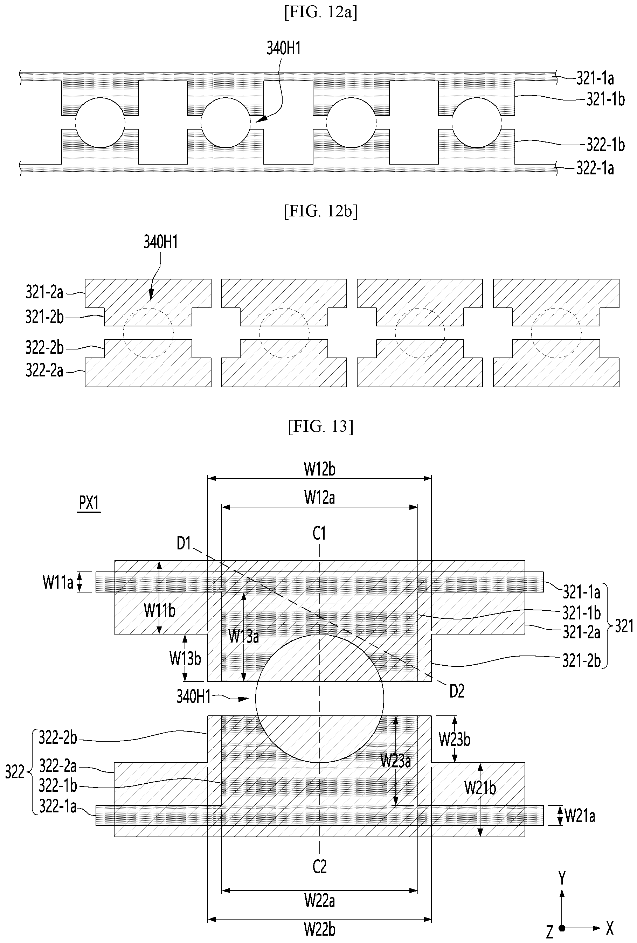

Referring now to FIGS. 12A and 12B, first assembly wiring 321 and second assembly wiring 322 will be described in detail.

FIG. 12A is a plan view illustrating a first bus line and a first extending line having a first assembly wiring and a second bus line and a second extending line having a second assembly wiring on an assembly substrate according to an embodiment.

As shown in FIGS. 11 and 12A, a first bus line 321-1a and a first extending line 321-1b including the first assembly wiring 321 may be disposed, and a second bus line 322-1a and a second extending line 322-1b including the second assembly wiring 322 may be disposed.

The first bus line 321-1a may supply an externally applied alternating voltage to each of the plurality of sub-pixels PX1, PX2, and PX3. For example, the first bus line 321-1a may be disposed across the plurality of first sub-pixels PX1 arranged along the first direction X to supply an externally applied first alternating voltage to each of the plurality of first sub-pixels PX1. For example, the first bus line 321-1a may be disposed across the plurality of second sub-pixels PX2 arranged along the first direction X to supply an externally applied second alternating voltage to each of the plurality of second sub-pixels PX2. For example, the first bus line 321-1a may be disposed across a plurality of third sub-pixels PX3 arranged along the first direction X to supply an externally applied third alternating voltage to each of the plurality of third sub-pixels PX3.

The amplitudes of each of the first alternating voltage, the second alternating voltage, and the third alternating voltage may be different. For example, the amplitude of each of the first alternating voltage, the second alternating voltage, and the third alternating voltage may vary depending on the shape, i.e., size or depth, of each of the first assembly hole 340H1 of the first sub-pixel PX1, the second assembly hole 340H2 of the second sub-pixel PX2, and the third assembly hole 340H3 of the third sub-pixel PX3. For example, the amplitude of each of the first alternating voltage, the second alternating voltage, and the third alternating voltage may vary depending on the shape, i.e., diameter or thickness, of each of the first semiconductor light-emitting device 150 assembled in the first assembly hole 340H1, the second semiconductor light-emitting device assembled in the second assembly hole 340H2, and the third semiconductor light-emitting device assembled in the third assembly hole 340H3. Alternatively, the amplitude (A1 in FIG. 2) of each of the first alternating voltage, the second alternating voltage, and the third alternating voltage may be the same.

The first extending line 321-1b may be formed integral with the first bus line 321-1a, but is not limited thereto.

The first extending line 321-1b may extend along the second direction (Y) from the first bus line 321-1a. For example, the first extending line 321-1b may extend from the first bus line 321-1a towards the assembly holes 340H1, 340H2, 340H3.

The first extending line 321-1b may extend from the first bus line 321-1a at each of the plurality of sub-pixels PX1, PX2, PX3 toward the assembly holes 340H1, 340H2, 340H3. For example, the first extending line 321-1b may extend from the first bus line 321-1a towards the first assembly hole 340H1 at each of the plurality of first sub-pixels PX1 arranged along the first direction X. The first extending line 321-1b of each of the first sub-pixels PX1 may be disposed in the first assembly hole 340H1. The first extending line 321-1b of each of the first sub-pixels PX1 may abut the first assembly hole 340H1, but may not be vertically overlapped with the first assembly hole 340H1.

For example, the first extending line 321-1b may extend from the first bus line 321-1a toward the second assembly hole 340H2 from each of the plurality of second sub-pixels PX2 arranged along the first direction X. The first extending line 321-1b of each of the second sub-pixels PX2 may be disposed in the second assembly hole 340H2. The first extending line 321-1b of each of the second sub-pixels PX2 may abut the second assembly hole 340H2, but may not be vertically overlapped with the second assembly hole 340H2.

For example, the first extending line 321-1b may extend from the first bus line 321-1a towards the third assembly hole 340H3 in each of the plurality of third sub-pixels PX3 arranged along the first direction X. The first extending line 321-1b of each of the third sub-pixels (PX3) may be disposed in the third assembly hole 340H3. The first extending line 321-1b of each of the third sub-pixel PX3 may abut the third assembly hole 340H3, but may not be vertically overlapped with the third assembly hole 340H3.

Meanwhile, the second bus line 322-1a may supply an externally applied alternating voltage to each of the plurality of sub-pixels PX1, PX2, and PX3. The second bus line 322-1a may be disposed parallel to the first bus line 321-1a along the first direction X. For example, the second bus line 322-1a may be disposed across a plurality of first sub-pixels PX1 arranged along the first direction X to supply an externally applied first alternating voltage to each of the plurality of first sub-pixels PX1. For example, the second bus line 322-1a may be disposed across the plurality of second sub-pixels PX2 arranged along the first direction X to supply an externally applied second alternating voltage to each of the plurality of second sub-pixels PX2. For example, the second bus line 322-1a may be disposed across a plurality of third sub-pixels PX3 arranged along the first direction X to supply an externally applied third alternating voltage to each of the plurality of third sub-pixels PX3.

The amplitudes of each of the first alternating voltage, the second alternating voltage, and the third alternating voltage may be different. For example, the amplitude of each of the first alternating voltage, the second alternating voltage, and the third alternating voltage may vary depending on the shape, i.e., size or depth, of each of the first assembly hole 340H1 of the first sub-pixel PX1, the second assembly hole 340H2 of the second sub-pixel PX2, and the third assembly hole 340H3 of the third sub-pixel PX3. For example, the amplitude of each of the first alternating voltage, the second alternating voltage, and the third alternating voltage may vary depending on the shape, i.e., diameter or thickness, of each of the first semiconductor light-emitting device 150 assembled in the first assembly hole 340H1, the second semiconductor light-emitting device assembled in the second assembly hole 340H2, and the third semiconductor light-emitting device assembled in the third assembly hole 340H3. Alternatively, the amplitude (A1 in FIG. 2) of each of the first alternating voltage, the second alternating voltage, and the third alternating voltage may be the same.

As shown in FIG. 12a, the second extending line 322-1b may be formed integral with the second bus line 322-1a, but is not limited thereto. The second extending line 322-1b may be arranged to face the first extending line 321-1b with the first assembly hole 340H1 in between, i.e., the first assembly hole 340H1 may be positioned between the first extending line 321-1b and the second extending line 322-1b. Each of the first extending line 321-1b and the second extending line 322-1b may not overlap vertically with the first assembly hole 340H1.

The second extending line 322-1b may extend along a second direction (Y) from the second bus line 322-1a. For example, the second extending line 322-1b may extend from the second bus line 322-1a toward the first assembly hole 340H1.

The second extending line 322-1b may extend from the second bus line 322-1a at each of the plurality of sub-pixels PX1, PX2, XP3 toward the first assembly hole 340H1. For example, the second extending line 322-1b may extend from the second bus line 322-1a toward the first assembly hole 340H1 at each of the plurality of first sub-pixels PX1 arranged along the first direction X. The second extending line 322-1b of each of the first sub-pixels PX1 may be disposed in the first assembly hole 340H1. The second extending line 322-1b of each of the first sub-pixels PX1 may abut the first assembly hole 340H1, but may not be vertically overlapped with the first assembly hole 340H1.

For example, the second extending line 322-1b may extend from the second bus line 322-1a toward the second assembly hole 340H2 from each of the plurality of second sub-pixels PX2 arranged along the first direction X. A second extending line 322-1b of each of the second sub-pixels PX2 may be disposed in the second assembly hole 340H2. The second extending line 322-1b of each of the second sub-pixels PX2 may abut the second assembly hole 340H2, but may not be vertically overlapped with the second assembly hole 340H2.

For example, the second extending line 322-1b may extend from the second bus line 322-1a toward the third assembly hole 340H3 from each of the plurality of third sub-pixels PX3 arranged along the first direction X. The second extending line 322-1b of each of the third sub-pixels PX3 may be disposed in the third assembly hole 340H3. The second extending line 322-1b of each of the third sub-pixels PX3 may abut the third assembly hole 340H3, but may not be vertically overlapped with the third assembly hole 340H3.

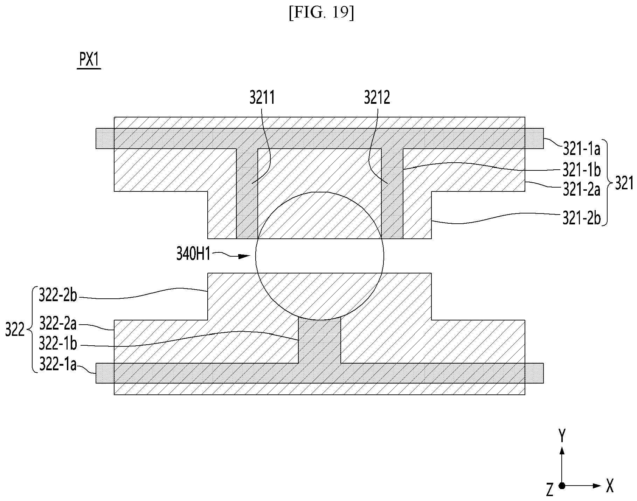

In one example, the first extending electrode 321-2b may include at least two or more electrodes extending from the first assembly electrode 321-2a, as shown in FIGS. 19 through 22.

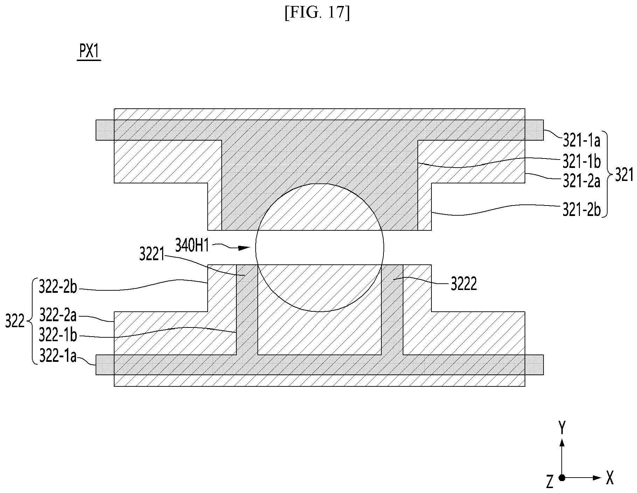

As another example, the second extending electrode 322-2b may include at least two or more electrodes 3211, 3212, 3213, 3221, 3222, 3223 extending from the second assembly electrode 322-2a (FIG. 17, FIG. 18, FIG. 20, FIG. 21, FIG. 24, and FIG. 25).

In one example, as shown in FIG. 13 and FIGS. 20 to 22, the first extending line 321-1b and the second extending line 322-1b may have a symmetrical structure with respect to each other, i.e., the first extending line 321-1b and the second extending line 322-1b may have a symmetrical structure with respect to a reference line crossing the center of the first assembly hole 340H1 along the first direction X. The first extending electrode 321-2b and the second extending electrode 322-2b may have a symmetrical structure with respect to each other, that is, the first extending electrode 321-2b and the second extending electrode 322-2b may have a symmetrical structure with respect to a reference line crossing the center of the first assembly hole 340H1 along the first direction X.

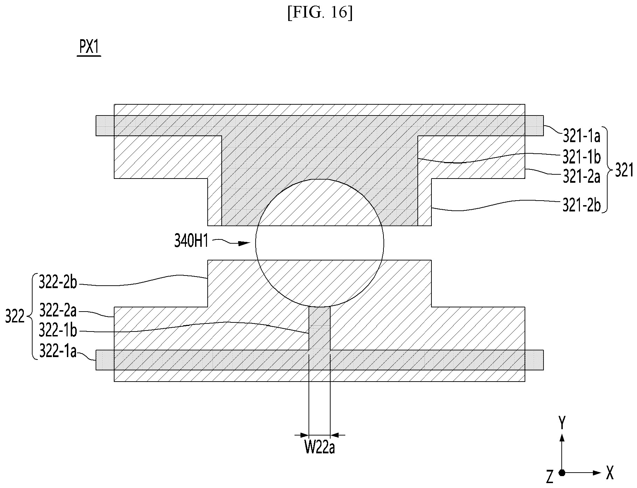

As another example, as shown in FIGS. 16 to 19 and FIGS. 23 to 25, the first extending line 321-1b and the second extending line 322-1b may have asymmetrical structures with respect to each other, i.e., the first extending line 321-1b and the second extending line 322-1b may have symmetrical structures with respect to each other with respect to a reference line crossing the center of the first assembly hole 340H1 along the first direction X. The first extending electrode 321-2b and the second extending electrode 322-2b may have a symmetrical structure with respect to each other, that is, the first extending electrode 321-2b and the second extending electrode 322-2b may have a symmetrical structure with respect to a reference line crossing the center of the first assembly hole 340H1 along the first direction X.

FIG. 12B is a plan view illustrating a first assembly electrode and first extending electrode having a first assembly wiring 321 and a second assembly electrode 322-2a and second extending electrode 322-2b having a second assembly wiring in an assembly substrate according to an embodiment.

As shown in FIGS. 11, 12, and 12B, a first assembly electrode 321-2a and a first extending electrode 321-2b having first assembly wiring 321 may be disposed, and a second assembly electrode 322-2a and a second extending electrode 322-2b having second assembly wiring 322 may be disposed.

The first assembly electrode 321-2a may be disposed on the first bus line 321-1a. The first assembly electrode 321-2a may be vertically overlapped with the first bus line 321-1a. The first assembly electrode 321-2a may be vertically connected to the first bus line 321-1a, i.e., a bottom surface of the first assembly electrode 321-2a may be in contact with a top surface of the first bus line 321-1a.

The first assembly wiring 321 may be individually disposed in the plurality of sub-pixels PX1, PX2, and PX3, i.e., the first assembly wiring 321 may be disposed in each of the plurality of sub-pixels PX1, PX2, and PX3 separately from each other. For example, the first assembly wiring 321 may be disposed separately in each of the plurality of first sub-pixels PX1 arranged along the first direction X. In other words, the first assembly wiring 321 disposed in each of the neighboring first sub-pixels PX1 may be spaced apart from each other. For example, the first assembly wiring 321 may be disposed separately in each of the plurality of second sub-pixels PX2 arranged along the first direction X. In other words, the first assembly wiring 321 disposed in each of the neighboring second sub-pixels PX2 may be spaced apart from each other. For example, the first assembly wiring 321 may be disposed separately from each other in each of a plurality of third sub-pixels PX3 arranged along the first direction X. In other words, the first assembly wiring 321 disposed in each of the neighboring third sub-pixels PX3 may be spaced apart from each other.

The first assembly electrode 321-2a may supply an alternating voltage supplied to the first bus line 321-1a from an external source to each of the plurality of sub-pixels PX1, PX2, and PX3. To this end, the first assembly electrode 321-2a may be electrically connected to the first bus line 321-1a at each of the plurality of sub-pixels PX1, PX2, and PX3. For example, the first assembly electrode 321-2a may be electrically connected to the first bus line 321-1a at each of the plurality of first sub-pixels PX1 arranged along the first direction X. For example, the first assembly electrode 321-2a may be electrically connected to the first bus line 321-1a at each of the plurality of second sub-pixels PX2 arranged along the first direction X. For example, the first assembly electrode 321-2a may be electrically connected to the first bus line 321-1a at each of the plurality of third sub-pixels PX3 arranged along the first direction X.

The first extending electrode 321-2b may be disposed on the first extending line 321-1b. The first extending electrode 321-2b may be vertically overlapped with the first extending line 321-1b. The first extending electrode 321-2b may be vertically connected to the first extending line 321-1b, i.e., the bottom surface of the first extending electrode 321-2b may be in contact with the top surface of the first extending line 321-1b. However, the first extending electrode 321-2b may not be vertically overlapped with the first extending line 321-1b in the first assembly hole 340H1. The first extending line 321-1b may not be vertically overlapped with the first assembly hole 340H1, and the first extending electrode 321-2b may be vertically overlapped with the first assembly hole 340H1.

The first extending line 321-1b is not vertically overlapping the first assembly hole 340H1, but is arranged to be tangential to the first assembly hole 340H1, so that the alternating voltage supplied by the first bus line 321-1a can be supplied as close to the first assembly hole 340H1 as possible, thereby reducing the line resistance of the first assembly electrode 321-2a and the first extending electrode 321-2b. In other words, the alternating voltage supplied by the first bus line 321-1a can be supplied into the first assembly hole 340H1 via the first assembly electrode 321-2a and the first extending electrode 321-2b.

The thickness of each of the first assembly electrode 321-2a and the first extending electrode 321-2b is thin because if the thickness of each of the first assembly electrode 321-2a and/or the first extending electrode 321-2b is thick, the DEP force formed within the first assembly hole 340H1 will be uneven, thereby reducing the assembly force of the semiconductor light emitting device 150. For example, the thickness of the first assembly electrode 321-2a may be less than the thickness of the first bus line 321-1a. For example, the thickness of the first extending electrode 321-2b may be less than the thickness of the first extending line 321-1b. For example, the thickness of each of the first assembly electrode 321-2a and/or the first extending electrode 321-2b may be 200 nm or less. For example, the thickness of each of the first assembly electrode 321-2a and/or the first extending electrode 321-2b may be between 10 and 200 nm.

Since the thickness of each of the first assembly electrode 321-2a and/or the first extending electrode 321-2b is small, the line resistance may be large. Accordingly, by having the first extending line 321-1b extend from the first bus line 321-1a to contact the first assembly hole 340H1 and connect perpendicularly to the first extending electrode 321-2b, the decrease in line resistance of the first assembly electrode 321-2a and/or the first extending electrode 321-2b may be prevented (or compensated for), and signal distortion of the alternating voltage may be suppressed. Since the original alternating voltage, i.e., an alternating voltage having an amplitude equal to the amplitude of the target value, is supplied to the first assembly hole 340H1, and the DEP force formed by this alternating voltage is not reduced and is equal to or similar to the target DEP force, the assembly rate of the semiconductor light-emitting device 150 may be improved.

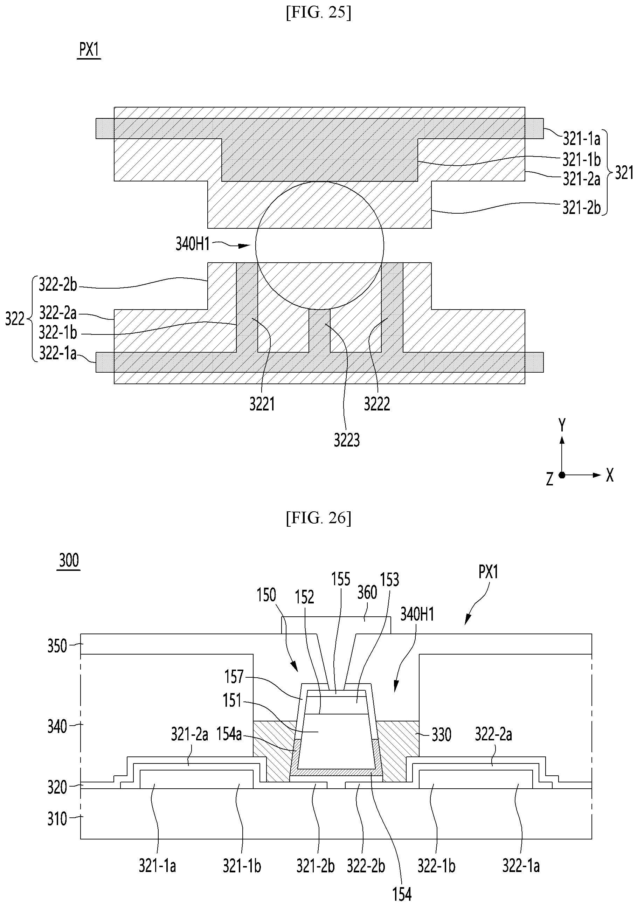

In particular, in the display device 300 of FIG. 26 having a high-resolution, high-fidelity, and large screen, the embodiment may improve the assembly rate by preventing signal distortion of the alternating voltage even if the line width of each of the second bus line 322-1a, the second extending line 322-1b, the second assembly electrode 322-2a, and the second extending electrode 322-2b for self-assembly is reduced.

The first extending electrode 321-2b may be integrally formed with the first assembly electrode 321-2a, but is not limited thereto. The first extending electrode 321-2b may extend along the second direction (Y) from the first assembly electrode 321-2a. For example, the first extending electrode 321-2b may extend from the first assembly electrode 321-2a toward the first assembly hole 340H1.

The first extending electrode 321-2b may extend from the first assembly electrode 321-2a toward the first assembly hole 340H1 in each of the plurality of sub-pixels.

For example, the first extending electrode 321-2b may extend from the first assembly electrode 321-2a toward the first assembly hole 340H1 in each of the plurality of first sub-pixels PX1 arranged along the first direction X. A first extending electrode 321-2b of each of the first sub-pixels PX1 may be disposed in the first assembly hole 340H1. The first extending electrode 321-2b of each of the first sub-pixels PX1 may be vertically overlapped with the first assembly hole 340H1.

For example, the first extending electrode 321-2b may extend from the first assembly electrode 321-2a towards the second assembly hole 340H2 in each of the plurality of second sub-pixels PX2 arranged along the first direction X. A first extending electrode 321-2b of each of the second sub-pixels PX2 may be disposed in the second assembly hole 340H2. The first extending electrode 321-2b of each of the second sub-pixels PX2 may be vertically overlapped with the second assembly hole 340H2.

For example, the first extending electrode 321-2b may extend from the first assembly electrode 321-2a toward the third assembly hole 340H30 in each of the plurality of third sub-pixels PX3 arranged along the first direction X. The first extending electrode 321-2b of each of the third sub-pixels PX3 may be disposed in the third assembly hole 340H3. The first extending electrode 321-2b of each of the third sub-pixels PX3 may be vertically overlapped with the third assembly hole 340H3.

Meanwhile, the second assembly electrode 322-2a may be disposed on the second bus line 322-1a. The second assembly electrode 322-2a may be vertically overlapped with the second bus line 322-1a. The second assembly electrode 322-2a may be vertically connected to the second bus line 322-1a, i.e., a bottom surface of the second assembly electrode 322-2a may be in contact with a top surface of the second bus line 322-1a.

The second assembly wiring 322 may be disposed separately in the plurality of sub-pixels PX1, PX2, and PX3, i.e., the second assembly wiring 322 may be disposed separately in each of the plurality of sub-pixels PX1, PX2, and PX3. For example, the second assembly wiring 322 may be disposed separately from each other in each of the plurality of first sub-pixels PX1 arranged along the first direction X. In other words, the second assembly wiring 322 disposed in each of the neighboring first sub-pixels PX1 may be spaced apart from each other. For example, the second assembly wiring 322 may be disposed in each of a plurality of second sub-pixels PX2 arranged along the first direction X. In other words, the second assembly wiring 322 disposed in each of the neighboring second sub-pixels PX2 may be spaced apart from each other. For example, the second assembly wiring 322 may be disposed separately from each of the plurality of third sub-pixels PX3 arranged along the first direction X. That is, the second assembly wiring 322 disposed in each of the neighboring third sub-pixels PX3 may be spaced apart from each other.

The second assembly electrode 322-2a can supply an externally applied alternating voltage to each of the plurality of sub-pixels PX1, PX2, and PX3.

To this end, the second assembly electrode 322-2a may be electrically connected to the second bus line 322-1a at each of the plurality of sub-pixels. For example, the second assembly electrode 322-2a may be electrically connected to the second bus line 322-1a at each of the plurality of first sub-pixels PX1 arranged along the first direction X. For example, the second assembly electrode 322-2a may be electrically connected to the second bus line 322-1a at each of the plurality of second sub-pixels PX2 arranged along the first direction X. For example, the second assembly electrode 322-2a may be electrically connected to the second bus line 322-1a at each of the plurality of third sub-pixels PX3 arranged along the first direction X.

The second extending electrode 322-2b may be disposed on the second extending line 322-1b. The second extending electrode 322-2b may be vertically overlapped with the second extending line 322-1b. The second extending electrode 322-2b may be vertically connected to the second extending line 322-1b, i.e., the underside of the second extending electrode 322-2b may be in contact with the upper surface of the second extending line 322-1b. However, the second extending electrode 322-2b may not be vertically overlapped with the second extending line 322-1b in the first assembly hole 340H1. The second extending line 322-1b may not be vertically overlapped with the first assembly hole 340H1, and the second extending electrode 322-2b may be vertically overlapped with the first assembly hole 340H1.

The second extending line 322-1b is not vertically overlapping the first assembly hole 340H1, but is arranged to be tangential to the first assembly hole 340H1, so that the alternating voltage supplied by the second bus line 322-1a can be supplied as close to the first assembly hole 340H1 as possible, thereby reducing the line resistance of the second assembly electrode 322-2a and the second extending electrode 322-2b. In other words, the alternating voltage supplied by the second bus line 322-1a can be supplied into the first assembly hole 340H1 through the second assembly electrode 322-2a and the second extending electrode 322-2b.

The thickness of each of the second assembly electrode 322-2a and the second extending electrode 322-2b is thin because if the thickness of each of the second assembly electrode 322-2a and/or the second extending electrode 322-2b is thick, the DEP force formed within the first assembly hole 340H1 will be uneven, thereby reducing the assembly force of the semiconductor light emitting device 150. For example, the thickness of the second assembly electrode 322-2a may be less than the thickness of the second bus line 322-1a. For example, the thickness of the second extending electrode 322-2b may be less than the thickness of the second extending line 322-1b. For example, the thickness of each of the second assembly electrode 322-2a and/or the second extending electrode 322-2b may be 200 nm or less. For example, the thickness of each of the second assembly electrode 322-2a and/or the second extending electrode 322-2b may be between 10 and 200 nm.

Since the thickness of each of the second assembly electrode 322-2a and/or the second extending electrode 322-2b is small, the line resistance may be large. Accordingly, by having the second extending line 322-1b extend from the second bus line 322-1a toward the first assembly hole 340H1 and connect perpendicularly to the second extending electrode 322-2b, the decrease in line resistance of each of the second assembly electrode 322-2a and/or the second extending electrode 322-2b may be prevented (or compensated for), so that signal distortion of the alternating voltage may be suppressed. An original alternating voltage, i.e., an alternating voltage having an amplitude equal to the amplitude of the target value, is supplied to the first assembly hole 340H1, and the DEP force formed by this alternating voltage is not reduced, which may improve the assembly rate of the semiconductor light-emitting device 150.

In particular, in the display device 300 having a high-resolution, high-fidelity, and large screen, the embodiments may improve the assembly rate by preventing signal distortion of the alternating voltage even if the line width of each of the second bus line 322-1a, the second extending line 322-1b, the second assembly electrode 322-2a, and the second extending electrode 322-2b for self-assembly is reduced.

The second extending electrode 322-2b may be integrally formed with the second assembly electrode 322-2a, but is not limited thereto. The second extending electrode 322-2b may be arranged to face the first extending electrode 321-2b with the first assembly hole 340H1 in between, i.e., the first assembly hole 340H1 may be positioned between the first extending electrode 321-2b and the second extending electrode 322-2b. Each of the first extending electrode 321-2b and the second extending electrode 322-2b may not overlap vertically with the first assembly hole 340H1.

The second extending electrode 322-2b may extend along a second direction (Y) from the second assembly electrode 322-2a. For example, the second extending electrode 322-2b may extend from the second assembly electrode 322-2a toward the first assembly hole 340H1.

The second extending electrode 322-2b may extend from the second assembly electrode 322-2a toward the first assembly hole 340H1 at each of the plurality of subpixels PX1, PX2, and PX3.

For example, the second extending electrodes 322-2b may extend from the second assembly electrodes 322-2a toward the first assembly hole 340H1 in each of the plurality of first sub-pixels PX1 arranged along the first direction X. A second extending electrode 322-2b of each of the first sub-pixels PX1 may be disposed in the first assembly hole 340H1. The second extending electrodes 322-2b of each of the first sub-pixels PX1 may not overlap vertically with the first assembly hole 340H1.

For example, the second extending electrode 322-2b may extend from the second assembly electrode 322-2a toward the second assembly hole 340H2 in each of the plurality of second sub-pixels PX2 arranged along the first direction X. A second extending electrode 322-2b of each of the second sub-pixels PX2 may be disposed in the second assembly hole 340H2. The second extending electrodes 322-2b of each of the second sub-pixels PX2 may not overlap vertically with the second assembly hole 340H2.

For example, the second extending electrode 322-2b may extend from the second assembly electrode 322-2a toward the third assembly hole 340H3 in each of the plurality of third sub-pixels PX3 arranged along the first direction X. A second extending electrode 322-2b of each of the third sub-pixels PX3 may be disposed in the third assembly hole 340H3. The second extending electrodes 322-2b of each of the third sub-pixels PX3 may not overlap vertically with the third assembly hole 340H3.

Hereinafter, various embodiments of each of the first assembly wiring 321 and the second assembly wiring 322 will be described with reference to FIGS. 13 through 25. While the first assembly wiring 321 and the second assembly wiring 322 shown in each of FIGS. 13 through 25 illustrate the first subpixel PX1, the second subpixel PX2, and the third subpixel PX3 of the assembly substrate 300A shown in FIG. 11, the first subpixel PX1 is shown, the second sub-pixel PX2 and/or the third sub-pixel PX3 may also employ the same or a variation of the first assembly wiring 321 and the second assembly wiring 322 shown in FIGS. 13 through 25.

### [A first embodiment].

FIG. 13 is a first embodiment, an enlarged top view of a first sub-pixel of an assembly substrate according to the embodiment of FIG. 11.

As shown in FIG. 13, the first assembly wiring 321 may include a first bus line 321-1a, a first extending line 321-1b, a first assembly electrode 321-2a, and a first extending electrode 321-2b. The second assembly wiring 322 may include a second bus line 322-1a, a second extending line 322-1b, a second assembly electrode 322-2a, and a second extending electrode 322-2b.

The first bus line 321-1a and the second bus line 322-1a may be disposed parallel to each other along the first direction X, but are not limited thereto. The first bus line 321-1a may be disposed across a plurality of first sub-pixels PX1, a plurality of second sub-pixels PX2, or a plurality of third sub-pixels PX3, each arranged along the first direction X. The second bus line 322-1a may be disposed across the plurality of first sub-pixels PX1, the plurality of second sub-pixels PX2, or the plurality of third sub-pixels PX3 arranged along the first direction X. Accordingly, the first bus line 321-1a and the second bus line 322-1a may serve to supply an externally provided alternating voltage to each of the plurality of sub-pixels.

The first extending line 321-1b may extend from the first bus line 321-1a toward the first assembly hole 340H1, and the second extending line 322-1b may extend from the second bus line 322-1a toward the first assembly hole 340H1. The first extending line 321-1b and the second extending line 322-1b may be arranged to face each other across the first assembly hole 340H1.

The first assembly electrode 321-2a and the second assembly electrode 322-2a may be disposed parallel to each other along the first direction X, but are not limited thereto. The first assembly electrode 321-2a may be disposed on the first bus line 321-1a, and the second assembly electrode 322-2a may be disposed on the second bus line 322-1a. A bottom surface of the first assembly electrode 321-2a may be in contact with a top surface of the first bus line 321-1a, and a bottom surface of the second assembly electrode 322-2a may be in contact with a top surface of the second bus line 322-1a. Accordingly, the first assembly electrode 321-2a may serve to quickly and smoothly transmit the alternating voltage supplied to the plurality of sub-pixels to the first assembly hole 340H1 via the first extending electrode 321-2b. The second assembly electrode 322-2a may serve to quickly and smoothly transfer the alternating voltage supplied to the plurality of sub-pixels through the second extending electrode 322-2b to the first assembly hole 340H1.

The first assembly electrode 321-2a may surround the first bus line 321-1a, and the second assembly electrode 322-2a may surround the second bus line 322-1a. For example, the width W11b of the first assembly electrode 321-2a may be larger than the width W11a of the first bus line 321-1a. For example, the width W21b of the second assembly electrode 322-2a may be larger than the width W21b of the second bus line 322-1a.

The first extending electrode 321-2b may be disposed on the first extending line 321-1b, and the second extending electrode 322-2b may be disposed on the second extending line 322-1b. A bottom surface of the first extending electrode 321-2b may be in contact with a top surface of the second extending line 322-1b, and a top surface of the second extending electrode 322-2b may be in contact with a top surface of the second extending line 322-1b. The first extending electrode 321-2b may extend from the first assembly electrode 321-2a toward the first assembly hole 340H1, and the second extending electrode 322-2b may extend from the second assembly electrode 322-2a toward the first assembly hole 340H1. The first extending electrode 321-2b and the second extending electrode 322-2b may be disposed to face each other in the first assembly hole 340H1.

In an embodiment, the first extending line 321-1b is electrically connected with the first bus line 321-1a and vertically overlapped with the first extending electrode 321-2b, which can serve to maintain or reduce the line resistance of the first assembly wiring 321 to quickly and smoothly transfer the alternating voltage delivered to the plurality of sub-pixels PX1, PX2, PX3 to the first assembly hole 340H1. Furthermore, the second extending line 322-1b is electrically connected to the second bus line 322-1a and vertically overlapped with the second extending electrode 322-2b, which can serve to maintain or reduce the line resistance of the second assembly wiring 322, thereby quickly and smoothly transmitting the alternating voltage transmitted to the plurality of sub-pixels PX1, PX2, and PX3 to the first assembly hole 340H1.

The first extending electrode 321-2b may surround the first extending line 321-1b, and the second extending electrode 322-2b may surround the second extending line 322-1b. For example, the width W12b of the first extending electrode 321-2b along the first direction X may be larger than the width W12a of the first extending line 321-1b, and the width W13b of the first extending electrode 321-2b along the second direction Y may be smaller than the width W13a of the first extending line 321-1b. For example, the width W22b of the second extending electrode 322-2b along the first direction (X) may be larger than the width W22a of the second extending line 322-1b, and the width W23b of the second extending electrode 322-2b along the second direction (Y) may be smaller than the width W23a of the second extending line 322-1b.

On the other hand, each of the first extending line 321-1b, the second extending line 322-1b, the first assembly electrode 321-2a, the second assembly electrode 322-2a, the first extending electrode 321-2b, and the second extending electrode 322-2b may be disposed on each of the plurality of second sub-pixels PX2, each of the plurality of second sub-pixels PX2, or each of the plurality of third sub-pixels PX3. In other words, each of the first extending line 321-1b, the second extending line 322-1b, the first assembly electrode 321-2a, the second assembly electrode 322-2a, the first extending electrode 321-2b, and the second extending electrode 322-2b may not be disposed across each of the plurality of first subpixels PX2, each of the plurality of second subpixels PX2, or each of the plurality of third subpixels PX3.

The first extending line 321-1b and the second extending line 322-1b may not be located within the first assembly hole 340H1, i.e., each of the first extending line 321-1b and the second extending line 322-1b may not be vertically overlapped with the first assembly hole 340H1. The first extending electrode 321-2b and the second extending electrode 322-2b may be positioned within the first assembly hole 340H1, i.e., each of the first extending electrode 321-2b and the second extending electrode 322-2b may be vertically overlapped with the first assembly hole 340H1.

FIG. 14 is a cross-sectional view along lines C1-C2 of the first sub-pixel of FIG. 13. FIG. 15 is a cross-sectional view along lines D1-D2 of the first sub-pixel of FIG. 13.

An assembly substrate (310A in FIG. 11) according to an embodiment may include a substrate 310, first assembly wiring 321, second assembly wiring 322, first insulating layer 320, and a partition wall 340.

The substrate 310 may be a support member to support components disposed on the substrate 310, or it may be a protective member to protect the components. The substrate 310 has been described previously and is therefore omitted.

The first and second assembly wiring 321, 322 may be disposed on the substrate 310. The first and second assembly wiring 321, 322 may serve to assemble the semiconductor light emitting device 150 of FIG. 27 into the first assembly hole 340H1 in a self-assembly manner. That is, in self-assembly, an electric field is generated between the first and second assembly wiring 321, 322 by the voltage supplied to the first and second assembly wiring 321, 322, and the semiconductor light-emitting device 150 being moved by the assembly device 1100 of FIG. 10 by the dielectrophoretic force formed by this electric field may be assembled in the first assembly hole 340H1.

Although the drawings show the first assembly wiring 321 and the second assembly wiring 322 being disposed on the same layer, i.e., on the top surface of the substrate 310, they may be disposed on different layers.

The first insulating layer 320 may be disposed on the first assembly wiring 321 and the second assembly wiring 322. The first insulating layer 320 may serve to protect the first assembly wiring 321 and the second assembly wiring 322. The first insulating layer 320 may prevent electrical shorts between the first assembly wiring 321 and the second assembly wiring 322. To this end, the first insulating layer 320 may be made of a material having good insulating properties. The first insulating layer 320 may contribute to the formation of a DEP force. For this purpose, the first insulating layer 320 may be made of a material with a high dielectric constant. The first insulating layer 320 may be formed of, but is not limited to, an inorganic material.

The partition wall 340 may be disposed on the substrate 310 and may have a first assembly hole 340H1. The plurality of sub-pixels PX1, PX2, PX3 may each include at least one assembly hole (340H1, 340H2, 340H3 in FIG. 11). The partition wall 340 may be disposed over the first assembly wiring 321 and the second assembly wiring 322. For example, the assembly holes 340H1, 340H2, and 340H3 may be provided on the first assembly wiring 321 and the second assembly wiring 322. The thickness of the partition wall 340 may be determined by considering the thickness of the semiconductor light emitting device 150. For example, the thickness of the partition wall 340 may be less than the thickness of the semiconductor light emitting device 150. Accordingly, the top side of the semiconductor light emitting device 150 may be positioned higher than the top surface of the partition wall 340. That is, the top side of the semiconductor light emitting device 150 may protrude in an upward direction from the top surface of the partition wall 340.

The size of the assembly holes 340H1, 340H2, and 340H3 may be determined by considering a tolerance margin for forming the assembly holes 340H1, 340H2, and 340H3 and a margin for facilitating assembly of the semiconductor light emitting device 150 within the assembly holes 340H1, 340H2, and 340H3. For example, the size of the assembly holes 340H1, 340H2, 340H3 may be larger than the size of the semiconductor light emitting device 150. For example, when the semiconductor light emitting device 150 is assembled in the center of the assembly holes 340H1, 340H2, 340H3, the distance between an outer side of the semiconductor light emitting device 150 and an inner side of the assembly holes 340H1, 340H2, 340H3 may be 2 µm or less, but is not limited thereto.

For example, the assembly holes 340H1, 340H2, 340H3 may have a shape corresponding to the shape of the semiconductor light emitting device 150. For example, if the semiconductor light emitting device 150 is circular, the assembly holes 340H1, 340H2, 340H3 may also be circular. For example, if the semiconductor light emitting device 150 is rectangular, the assembly holes 340H1, 340H2, 340H3 may also be rectangular.

In one example, the assembly holes 340H1, 340H2, 340H3 in each of the first sub-pixel PX1, the second sub-pixel PX2, and the third sub-pixel PX3 may have the same shape, i.e., a circular shape. In such a case, the first semiconductor light-emitting device 150 disposed in the first subpixel PX1, the second semiconductor light-emitting device disposed in the second subpixel PX2, and the third semiconductor light-emitting device disposed in the third subpixel PX3 may have a shape corresponding to the assembly holes 340H1, 340H2, 340H3, that is, a circular shape.

As such, if the assembly holes 340H1, 340H2, 340H3 in each of the first sub-pixel (PX1), the second sub-pixel (PX2), and the third sub-pixel (PX3) have the same shape, the first semiconductor light emitting device 150, the second semiconductor light-emitting device, and the third semiconductor light-emitting device may be assembled in the assembly holes 340H1, 340H2, 340H3 of each of the corresponding sub-pixels PX1, PX2, PX3 in sequence, but without limitation. For example, the first semiconductor light emitting device 150 is assembled in the assembly holes 340H1, 340H2, 340H3 of the first sub-pixel PX1 of the substrate 310, and the second semiconductor light emitting device is assembled in the assembly holes 340H1, 340H2, 340H3) of the second sub-pixel PX2 of the substrate 310, and the third semiconductor light emitting device may be assembled in the assembly holes 340H1, 340H2, 340H3 of the third sub-pixel PX3 of the substrate 310. In this case, each of the first semiconductor light emitting device 150, the second semiconductor light emitting device, and the third semiconductor light emitting device may have the same shape, but is not limited thereto. Each of the assembly holes 340H1, 340H2, and 340H3 may have a shape corresponding to the shape of each of the first semiconductor light-emitting device 150, the second semiconductor light-emitting device, and the third semiconductor light-emitting device, but may have a size larger than the size of each of the first semiconductor light-emitting device 150, the second semiconductor light-emitting device, and the third semiconductor light-emitting device.

As another example, the assembly holes 340H1, 340H2, 340H3 in each of the first subpixel PX1, the second subpixel PX2, and the third subpixel PX3 may have different shapes. For example, the first assembly hole 340H1 in the first sub-pixel PX1 may have a circular shape, the second assembly hole 340H2 in the second sub-pixel PX2 may have a first elliptical shape with a first short axis and a first long axis, and the third assembly hole 340H3 in the third sub-pixel PX3 may have a second elliptical shape with a second short axis smaller than the first short axis and a second long axis larger than the first long axis. In such a case, the first semiconductor light-emitting device 150 may have a shape corresponding to the first assembly hole 340H1 in the first subpixel PX1, that is, a circle, the second semiconductor light-emitting device may have a shape corresponding to the second assembly hole 340H2 in the second subpixel PX2, that is, a first ellipse, and the third semiconductor light-emitting device may have a shape corresponding to the third assembly hole 340H3 in the third subpixel PX3, that is, a second ellipse.

By the assembly holes 340H1, 340H2, 340H3 having different shapes and the first to third semiconductor light-emitting devices 150 having shapes corresponding to each of the assembly holes 340H1, 340H2, 340H3, the first to third semiconductor light-emitting devices 150 can be assembled in the corresponding assembly holes 340H1, 340H2, 340H3 at the same time during self-assembly. That is, even if the first semiconductor light-emitting device 150, the second semiconductor light-emitting device, and the third semiconductor light-emitting device are mixed in the fluid 1200 for self-assembly, semiconductor devices corresponding to the assembly holes 340H1, 340H2, 340H3 of each of the first sub-pixel PX1, the second sub-pixel PX2, and the third sub-pixel PX3 on the substrate 310 may be assembled. That is, in the first assembly hole 340H1 of the first sub-pixel PX1, a first semiconductor light emitting device 150 having a shape corresponding to the shape of the first assembly hole 340H1 may be assembled. In the second assembly hole 340H2 of the second sub-pixel PX2, a second semiconductor light emitting device 150 having a shape corresponding to the shape of the second assembly hole 340H2 may be assembled. In the third assembly hole 340H3 of the third sub-pixel PX3, a third semiconductor light-emitting device having a shape corresponding to the shape of the third assembly hole 340H3 may be assembled. Thus, since the first semiconductor light-emitting device 150, the second semiconductor light-emitting device, and the third semiconductor light-emitting device each having different shapes are assembled in the assembly holes 340H1, 340H2, and 340H3 corresponding to their shapes, assembly defects can be prevented.

In the assembly substrate 310A configured as described above, when an alternating voltage is applied to the first assembly wiring 321 and the second assembly wiring 322 for self-assembly, a DEP force is formed between the first assembly wiring 321 and the second assembly wiring 322, and the semiconductor light emitting device 150 can be assembled in the assembly holes 340H1, 340H2, and 340H3 by this DEP force and fixed within the assembly holes 340H1, 340H2, and 340H3.

According to embodiments, assembly rates can be dramatically improved in display devices 300 having high resolution and/or high resolution.

According to embodiments, assembly rates can be dramatically improved in the display device 300 having a large screen.

According to embodiments, even if the line width is reduced by the display device 300 having a high-resolution, high-definition, or large screen, by constructing each of the first assembly wiring 321 and/or the second assembly wiring 322 in at least two or more layers, the line resistance of each of the first assembly wiring 321 and/or the second assembly wiring 322 can be reduced to prevent voltage drops or signal distortion of the alternating voltage, thereby improving the assembly rate.

According to an embodiment, even if the line width is reduced by the display device 300 having a high-resolution, high-definition, or large screen, the assembly rate can be improved by ensuring that at least two or more layers including each of the first assembly wiring 321 and/or the second assembly wiring 322 are positioned as close as possible to the assembly holes 340H1, 340H2, 340H3, thereby reducing the line resistance of each of the first assembly wiring 321 and/or the second assembly wiring 322 to prevent voltage drops or signal distortion of the alternating voltage, thereby improving the assembly rate.

According to an embodiment, even if the line width is reduced by the display device 300 having a high-resolution, high-definition or large screen, by ensuring that a thinner layer of the at least two layers including each of the first assembly wiring 321 and/or the second assembly wiring 322 is positioned within the assembly holes 340H1, 340H2, 340H3, the unevenness of the DEP force during self-assembly can be resolved, thereby preventing poor assembly or a decrease in the assembly rate of the semiconductor light emitting device 150.

### [A second Embodiment].

FIG. 16 is a second embodiment, an enlarged top view of a first sub-pixel of an assembly substrate according to the embodiment of FIG. 11.

The second embodiment is the same as the first embodiment (FIG. 13) except for the width W22a of the second extending line 322-1b, i.e., the width W22a of the second extending line 322-1b of the second embodiment may be smaller than the width W22a of the second extending line 322-1b of the first embodiment.

For example, the width W22a of the second extending line 322-1b may be smaller than the diameter of the first assembly hole 34H1. Even though the width W22a of the second extending line 322-1b is small, the second extending electrode 322-2b located within the first assembly hole 34H1 is electrically connected to the second assembly electrode 322-2a or the second extending line 322-1b, so that an alternating voltage can be quickly and smoothly supplied into the first assembly hole 34H1.

In the second embodiment, by extending the first extending line 321-1b and the second extending line 322-1b from the first bus line 321-1a and the second bus line 322-1a, respectively, toward the first assembly hole 34H1, the line resistance of the first assembly wiring 321 and the second assembly wiring 322, respectively, can be reduced to prevent voltage drop or signal distortion of the alternating voltage, thereby improving the assembly rate of the semiconductor light-emitting device 150.

### [A third Embodiment].

FIG. 17 is a third embodiment, an enlarged top view of a first sub-pixel of an assembly substrate according to the embodiment of FIG. 11.

The third embodiment is identical to the first embodiment (FIG. 13) except for the second extending line 322-1b.

As shown in FIG. 17, the second extending line 322-1b may include a first electrode 3221 and a second electrode 3222. The first electrode 3221 and the second electrode 3222 may each extend from the second extending line 322-1b toward the first assembly hole 34H1.

In a third embodiment, by extending the first extending line 321-1b and the second extending line 322-1b from the first bus line 321-1a and the second bus line 322-1a, respectively, toward the first assembly hole 34H1, the line resistance of the first assembly wiring 321 and the second assembly wiring 322, respectively, may be reduced to prevent voltage drop or signal distortion of the alternating voltage, thereby improving the assembly rate of the semiconductor light-emitting device 150.

### [A fourth Embodiment].

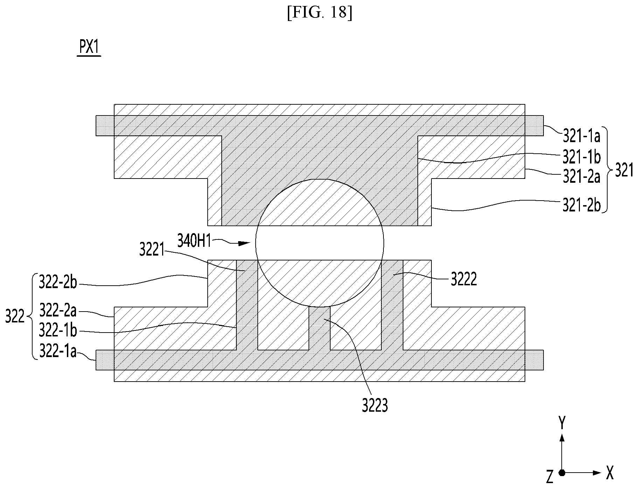

FIG. 18 is a fourth embodiment, an enlarged top view of a first sub-pixel of an assembly substrate according to the embodiment of FIG. 11.

The fourth embodiment is identical to the first embodiment (FIG. 13) except for the second extending line 322-1b.

As shown in FIG. 18, the second extending line 322-1b may include a first electrode 3221, a second electrode 3222, and a third electrode 3223. The first electrode 3221, second electrode 3222, and third electrode 3223 of the second extending line 322-1b may each extend from the second bus line 322-1a toward the first assembly hole 34H1.

On the other hand, the respective thicknesses of the first electrode 3221, the second electrode 3222, and the third electrode 3223 may be larger than the thickness of the second extending electrode 322-2b. Accordingly, when each of the first electrode 3221, the second electrode 3222, and the third electrode 3223 is disposed within the first assembly hole 34H1, the thickness is increased by each of the first electrode 3221, the second electrode 3222, and the third electrode 3223 and the second extending electrode 322-2b within the first assembly hole 34H1, The DEP force formed by the alternating voltage applied to the first assembly wiring 321 and the second assembly wiring 322 may become uneven, resulting in a decrease in the assembly rate of the semiconductor light emitting device 150. However, according to an embodiment, each of the first electrode 3221, the second electrode 3222, and the third electrode 3223 may be tangential to the first assembly hole 34H1. That is, the first electrode 3221, the second electrode 3222, and the third electrode 3223 may not each be vertically overlapped with the first assembly hole 34H1. Accordingly, the first electrode 3221, the second electrode 3222, and the third electrode 3223 may not be disposed within the first assembly hole 34H1, and only the second extending electrode 322-2b may be disposed, resulting in a reduced thickness, which may result in a uniform DEP force and improved assembly rate.

Furthermore, according to an embodiment, by extending the first extending line 321-1b and the second extending line 322-1b toward the first assembly hole 34H1 from the first bus line 321-1a and the second bus line 322-1a, respectively, the line resistance of the first assembly wiring 321 and the second assembly wiring 322 may be reduced to prevent voltage drop or signal distortion of the alternating voltage, thereby improving the assembly rate of the semiconductor light-emitting device 150.

### [A fifth Embodiment].

FIG. 19 is a fifth embodiment, an enlarged top view of a first sub-pixel of an assembly substrate according to the embodiment of FIG. 11.

As shown in FIG. 19, the first extending line 321-1b may include a first electrode 3211 and a second electrode 3212. The width W22a of the second extending line 322-1b may be smaller than the diameter of the first assembly hole 34H1.

The first electrode 3211 and the second electrode 3212 of the first extending line 321-1b may each extend from the first bus line 321-1a toward the first assembly hole 34H1.

According to an embodiment, the first electrode 3211 and the second electrode 3212 of the first extending line 321-1b are each not vertically overlapped with the first assembly hole 34H1, and the first extending electrode 321-2b is vertically overlapped with the first assembly hole 34H1, the first electrode 3211 and the second electrode 3212 of the first extending line 321-1b are not each disposed within the first assembly hole 34H1, and only the first extending electrode 321-2b can be disposed within the first assembly hole 34H1. Since the second extending line 322-1b is not vertically overlapped with the first assembly hole 34H1 and the second extending electrode 322-2b is vertically overlapped with the first assembly hole 34H1, each of the second extending line 322-1b is not disposed within the first assembly hole 34H1 and only the second extending electrode 322-2b may be disposed within the first assembly hole 34H1. Accordingly, since only the first extending electrode 321-2b and the second extending electrode 322-2b, which are thin in thickness, are disposed in the first assembly hole 34H1, the DEP force formed by the alternating voltage applied to the first assembly wiring 321 and the second assembly wiring 322 may be uniformized, thereby improving the assembly rate of the semiconductor light-emitting device 150.

Furthermore, according to an embodiment, by extending the first extending line 321-1b and the second extending line 322-1b toward the first assembly hole 34H1 from the first bus line 321-1a and the second bus line 322-1a, respectively, the line resistance of the first assembly wiring 321 and the second assembly wiring 322 may be reduced to prevent voltage drop or signal distortion of the alternating voltage, thereby improving the assembly rate of the semiconductor light-emitting device 150.

### [A sixth Embodiment].

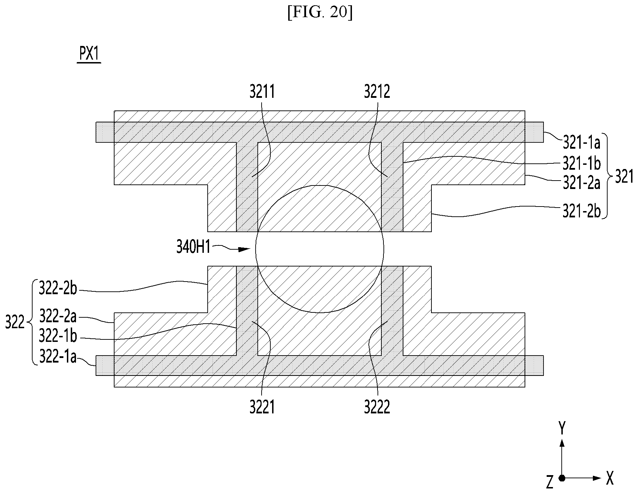

FIG. 20 is a sixth embodiment, an enlarged plan view of a first sub-pixel of an assembly substrate according to the embodiment of FIG. 11.

As shown in FIG. 20, the first extending line 321-1b may include a first electrode 3211 and a second electrode 3212. The second extending line 322-1b may include a first electrode 3221 and a second electrode 3222. The first electrode 3211 of the first extending line 321-1b and the first electrode 3221 of the second extending line 322-1b may have a symmetrical structure with respect to each other with respect to a reference line crossing the center of the first assembly hole 34H1 along the first direction X. With respect to a reference line crossing the center of the first assembly hole 34H1 along the first direction X, the second electrode 3212 of the first extending line 321-1b and the second electrode 3222 of the second extending line 322-1b may have a symmetrical structure with respect to each other.

The first electrode 3211 and the second electrode 3212 of the first extending line 321-1b may each extend from the first extending line 321-1b toward the first assembly hole 34H1. The first electrode 3221 and the second electrode 3222 of the second extending line 322-1b may each extend from the second extending line 322-1b toward the first assembly hole 34H1.

According to an embodiment, the first electrode 3211 and the second electrode 3212 of the first extending line 321-1b are each not vertically overlapped with the first assembly hole 34H1, and the first extending electrode 321-2b is vertically overlapped with the first assembly hole 34H1, the first electrode 3211 and the second electrode 3212 of the first extending line 321-1b are not each disposed within the first assembly hole 34H1, and only the first extending electrode 321-2b can be disposed within the first assembly hole 34H1. Since the first electrode 3221 and the second electrode 3222 of the second extending line 322-1b are each not vertically overlapped with the first assembly hole 34H1, and the second extending electrode 322-2b is vertically overlapped with the first assembly hole 34H1, the first electrode 3221 and the second electrode 3222 of the second extending line 322-1b are not each disposed within the first assembly hole 34H1, and only the second extending electrode 322-2b can be disposed within the first assembly hole 34H1. Accordingly, since only the first extending electrode 321-2b and the second extending electrode 322-2b, which are thin in thickness, are disposed in the first assembly hole 34H1, the DEP force formed by the alternating voltage applied to the first assembly wiring 321 and the second assembly wiring 322 may be uniformized, thereby improving the assembly rate of the semiconductor light emitting device 150.

Furthermore, according to an embodiment, by extending the first extending line 321-1b and the second extending line 322-1b toward the first assembly hole 34H1 from the first bus line 321-1a and the second bus line 322-1a, respectively, the line resistance of the first assembly wiring 321 and the second assembly wiring 322 may be reduced to prevent voltage drop or signal distortion of the alternating voltage, thereby improving the assembly rate of the semiconductor light-emitting device 150.

### [A Seventh Embodiment]

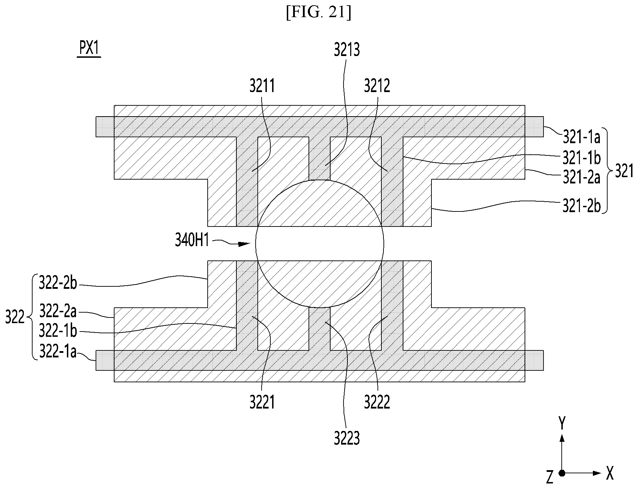

FIG. 21 is a seventh embodiment, an enlarged top view of a first sub-pixel of an assembly substrate according to the embodiment of FIG. 11.

The seventh embodiment is the same as the sixth embodiment (FIG. 20) except that the first extending line 321-1b and the second extending line 322-1b each further include a third electrode 3213, 3223.

As shown in FIG. 21, the first extending line 321-1b may include a first electrode 3211, a second electrode 3212, and a third electrode 3213. The second extending line 322-1b may include a first electrode 3221, a second electrode 3222, and a third electrode 3223. The first electrode 3211 of the first extending line 321-1b and the first electrode 3221 of the second extending line 322-1b may have a symmetrical structure with respect to each other with respect to a reference line crossing the center of the first assembly hole 34H1 along the first direction X. With respect to a reference line crossing the center of the first assembly hole 34H1 along the first direction X, the second electrode 3212 of the first extending line 321-1b and the second electrode 3222 of the second extending line 322-1b may have a symmetrical structure with respect to each other. With respect to a reference line crossing the center of the first assembly hole 34H1 along the first direction X, the third electrode 3213 of the first extending line 321-1b and the second electrode 3223 of the second extending line 322-1b may have a symmetrical structure with respect to each other.

The third electrode 3213 of the first extending line 321-1b may be positioned between the first electrode 3211 and the second electrode 3212. Each of the first electrode 3211, the second electrode 3212, and the third electrode 3213 of the first extending line 321-1b may have a different length. The length of the first electrode 3211 and the length of the second electrode 3212 may be the same. The length of the third electrode 3213 may be less than the length of the first electrode 3211 or the length of the second electrode 3212.

The third electrode 3223 of the second extending line 322-1b may be positioned between the first electrode 3221 and the second electrode 3222. Each of the first electrode 3221, second electrode 3222, and third electrode 3223 of the second extending line 322-1b may have a different length. The length of the first electrode 3221 and the length of the second electrode 3222 may be the same. The length of the third electrode 3223 may be less than the length of the first electrode 3221 or the length of the second electrode 3222.

The first electrode 3211, the second electrode 3212, and the third electrode 3213 of the first extending line 321-1b may each extend from the first extending line 321-1b toward the first assembly hole 34H1. The first electrode 3221, the second electrode 3222, and the third electrode 3223 of the second extending line 322-1b may each extend from the second extending line 322-1b toward the first assembly hole 34H1.

According to the embodiment, the first electrode 3211, the second electrode 3212, and the third electrode 3213 of the first extending line 321-1b are each not vertically overlapped with the first assembly hole 34H1, and the first extending electrode 321-2b is vertically overlapped with the first assembly hole 34H1, each of the first electrode 3211, the second electrode 3212, and the third electrode 3213 of the first extending line 321-1b are not disposed within the first assembly hole 34H1, and only the first extending electrode 321-2b can be disposed within the first assembly hole 34H1. Since the first electrode 3221, the second electrode 3222, and the third electrode 3223 of the second extending line 322-1b are each not vertically overlapped with the first assembly hole 34H1, and the second extending electrode 322-2b is vertically overlapped with the first assembly hole 34H1, each of the first electrode 3221, second electrode 3222, and third electrode 3223 of the second extending line 322-1b are not disposed within the first assembly hole 34H1, and only the second extending electrode 322-2b can be disposed within the first assembly hole 34H1. Accordingly, since only the first extending electrode 321-2b and the second extending electrode 322-2b, which are thin in thickness, are disposed in the first assembly hole 34H1, the DEP force formed by the alternating voltage applied to the first assembly wiring 321 and the second assembly wiring 322 may be uniformized, thereby improving the assembly rate of the semiconductor light emitting device 150.

Furthermore, according to an embodiment, by extending the first extending line 321-1b and the second extending line 322-1b toward the first assembly hole 34H1 from the first bus line 321-1a and the second bus line 322-1a, respectively, the line resistance of the first assembly wiring 321 and the second assembly wiring 322 may be reduced to prevent voltage drop or signal distortion of the alternating voltage, thereby improving the assembly rate of the semiconductor light-emitting device 150.

### [An Eighth Embodiment]

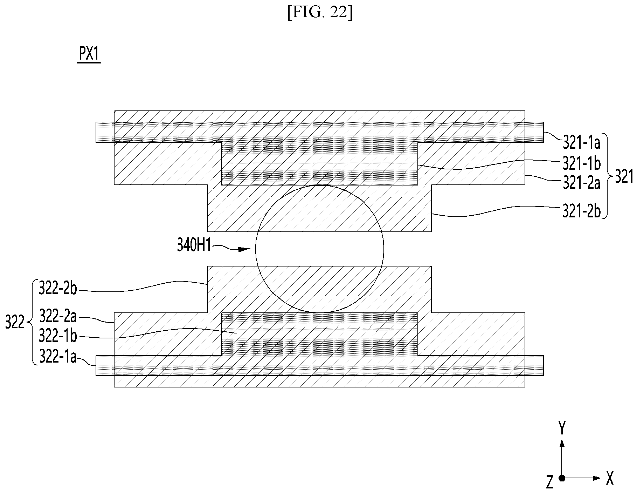

FIG. 22 is an eighth embodiment, an enlarged plan view of a first sub-pixel of an assembly substrate according to the embodiment of FIG. 11.

The eighth embodiment is identical to the first embodiment (FIG. 13) except for the first extending line 321-1b of the first assembly wiring 321 and the second extending line 322-1b of the second assembly wiring 322.

In the first embodiment (FIG. 13), the first extending line 321-1b and the second extending line 322-1b are each disposed along the periphery of the first assembly hole 34H1, whereas in the eighth embodiment, the first extending line 321-1b and the second extending line 322-1b are not each disposed along the periphery of the first assembly hole 34H1.

For example, the width W13a of the first extending line 321-1b along the second direction (Y) in the eighth embodiment may be smaller than the width W13a of the first extending line 321-1b along the second direction (Y) in the first embodiment. In the eighth embodiment, the width W23a of the second extending line 322-1b along the second direction (Y) may be smaller than the width W23a of the second extending line 322-1b along the second direction (Y) in the first embodiment.

For example, in the eighth embodiment, the first extending line 321-1b extends from the first bus line 321-1a and tangents the first assembly hole 34H1, but the end of the first extending line 321-1b that tangents the first assembly hole 34H1 may be positioned on a straight line. In an eighth embodiment, the second extending line 322-1b extends from the second bus line 322-1a and tangents the first assembly hole 34H1, but the end of the second extending line 322-1b that tangents the first assembly hole 34H1 may be positioned on a straight line.

### [A Ninth Embodiment]

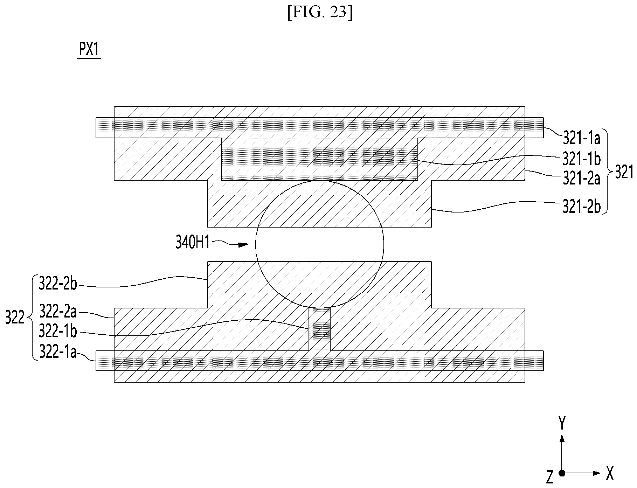

FIG. 23 is a ninth embodiment, an enlarged plan view of a first sub-pixel of an assembly substrate according to the embodiment of FIG. 11.

In the ninth embodiment, the width W22a of the second extending line 322-1b along the first direction X may be smaller than the width W22a of the second extending line 322-1b along the first direction X in the eighth embodiment (FIG. 22).

The remaining components have the same geometry or structure as in the eighth embodiment (FIG. 22).

### [A Tenth Embodiment].

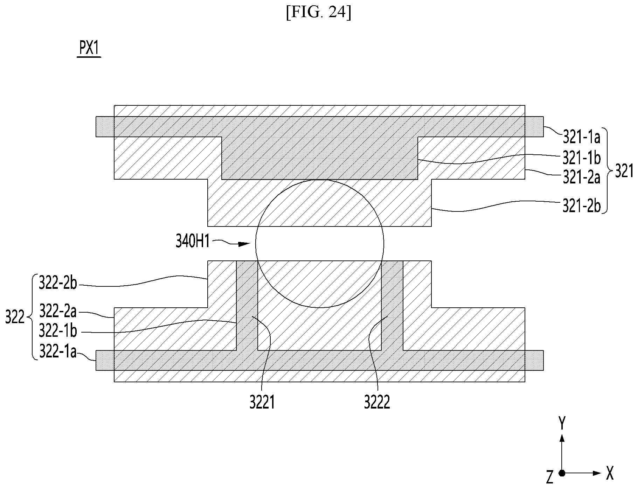

FIG. 24 is a tenth embodiment, an enlarged plan view of a first sub-pixel of an assembly substrate according to the embodiment of FIG. 11.

The tenth embodiment is the same as the eighth embodiment (FIG. 22) except for a second extending line 322-1b including two electrodes 3221, 3222.

The structure or shape of two electrodes 3221, 3222 can be readily understood from the description of the third embodiment (FIG. 17).

### [An Eleventh Embodiment].

FIG. 25 is an eleventh embodiment, an enlarged plan view of a first sub-pixel of an assembly substrate according to the embodiment of FIG. 11.

The eleventh embodiment is the same as the eighth embodiment (FIG. 22) except for a second extending line 322-1b including three electrodes 3221, 3222, 3223.

The structure or shape of these three electrodes 3221, 3222, 3223 can be readily understood from the description of the fourth embodiment (FIG. 18).

### [Display Devices].

FIG. 26 is a cross-sectional view illustrating a display device according to an embodiment. FIG. 27 is a cross-sectional view illustrating a semiconductor light emitting device provided in a display device according to an embodiment.

Referring to FIG. 26, a display device 300 according to an embodiment may include a substrate 310, first assembly wiring 321, second assembly wiring 322, first insulating layer 320, partition wall 340, semiconductor light emitting device 150, connecting electrodes 330, second insulating layer 350, and electrode wiring 360.

The substrate 310, first assembly wiring 321, second assembly wiring 322, first insulating layer 320, and partition wall 340 have been previously described with reference to FIG. 14 and will not be described in detail.

After the semiconductor light-emitting device 150 is assembled on the assembly substrate 300A shown in FIG. 14 using a self-assembly process, the connecting electrodes 330, the second insulating layer 350, and the electrode wiring 360 may each be formed by performing a post-process.

As described above, the structure or shape of the first assembly wiring 321 and the second assembly wiring 322 according to various embodiments (FIGS. 13, FIGS. 16 through 18, FIGS. 19 through 25) may result in no voltage drop or stretch distortion in the alternating voltage applied to the first assembly wiring 321 and the second assembly wiring 322, which may significantly improve the assembly rate of the semiconductor light emitting device 150 during self-assembly.

The semiconductor light emitting device 150 may include light emitting unit 151, 152, 153, a first electrode 154, a second electrode 155, and a passivation layer 157.

The light emitting unit may include a first conductive semiconductor layer 151 including a first dopant, an active layer 152 on the first conductive semiconductor layer, and a second conductive semiconductor layer 153 disposed on the active layer 152 and including a second dopant. For example, the first dopant may be an n-type dopant and the second dopant may be a p-type dopant.

In the embodiment, the semiconductor light-emitting device 150 is a vertical semiconductor light-emitting device, but it may also be a horizontal light-emitting device, a flip-chip light-emitting device, or the like.

The connection electrode 330 may be disposed in the first assembly hole 340H1. For example, the connection electrode 330 may electrically connect the first assembly wiring 321 and/or the second assembly wiring 322 with the first conductive semiconductor layer 151 of the semiconductor light emitting device 150 in the first assembly hole 340H1. For example, one side of the connection electrode 330 may be electrically connected to a side portion of the first conductive semiconductor layer 151 of the semiconductor light emitting device 150, and the other side of the connection electrode 330 may be electrically connected to a top surface portion of the first assembly wiring 321 and/or the second assembly wiring 322. For example, the connection electrode 330 may be electrically connected to the semiconductor light emitting device 150 along a side periphery of the first conductive semiconductor layer 151 of the semiconductor light emitting device 150. Accordingly, the contact area between the connecting electrode 330 and the first conductive semiconductor layer 151 is significantly increased, so that current can flow more quickly and smoothly from the first conductive semiconductor layer 151 to the connecting electrode 330, resulting in improved light efficiency.

As shown in FIG. 27, the first electrode 1540 may include an extension region 154a where the light emitting units 151, 152, 153 extend from the bottom to the side portions of the light emitting units 151, 152, 153. In such a case, the connection electrode 330 may be connected to the extension region 154a of the first electrode 1540 instead of the side portions of the first conductive semiconductor layer 151 of the semiconductor light emitting device 150, thereby allowing current to flow more rapidly and smoothly from the first conductive semiconductor layer 151 of the semiconductor light emitting device 150 to the connection electrode 330, thereby improving light efficiency.

For example, the connecting electrode 330 may contact a portion of the top surface of the first assembly wiring 321 and/or the second assembly wiring 322 through the first insulating layer 320. For example, the connecting electrode 330 may contact a side portion of the first electrode 154 of the semiconductor light emitting device 150. The thickness of the connecting electrode 330 may be less than the thickness of the partition wall 340.

In one aspect, the connecting electrode 330 may include at least one or more layers. For example, the connecting electrode 330 can include a metal that has good electrical conductivity, high reflectivity, and high thermal conductivity. The connecting electrode 330 can include aluminum (Al) or silver (Ag). Aluminum (Al) is prone to oxidation. Accordingly, the connecting electrode 330 may include molybdenum (Mo) to prevent oxidation of the aluminum (Al).

The connection electrode 330 may include a first layer, a second layer, and a third layer. The first layer may be disposed underneath the second layer, and the third layer may be disposed on top of the second layer. For example, the second layer may include aluminum or silver. At least one of the first layer or the second layer may comprise molybdenum.

The second insulating layer 350 may be disposed on the partition wall 340 to protect the semiconductor light emitting device 150. The second insulating layer 350 may be disposed in the first assembly hole 340H1 around the semiconductor, which may securely hold the semiconductor light emitting device 150. Furthermore, the second insulating layer 350 may be disposed on the semiconductor light emitting device 150 to protect the semiconductor light emitting device 150 from external impact and prevent it from being contaminated by foreign matter.

The second insulating layer 350 may serve as a leveling layer that allows the layer formed in a subsequent process to be formed with a constant thickness. Accordingly, the top surface of the second insulating layer 350 may have a flat surface. The second insulating layer 350 may be formed of an organic material or an inorganic material. Accordingly, the electrode wiring 360 can be easily formed on the top surface of the second insulating layer 350 having a flat surface without breaks.

The electrode wiring 360 may be disposed on each of the first sub-pixel PX1, the second sub-pixel PX2, and the third sub-pixel PX3. One side of the electrode wiring 360 may be connected to a signal line (not shown), and the other side of the electrode wiring 360 may be connected to the second electrode 155 of the semiconductor light emitting device 150.

For example, the electrode wiring 360 may be made of a transparent conductive material that is light transmissive. For example, the electrode wiring 360 may include, but is not limited to, ITO, IZO, and the like.

The semiconductor light emitting device 150 may be emitted by power supplied by the first assembly wiring 321 and/or the second assembly wiring 322 connected to the connection electrode 330 and the electrode wiring 360. The first assembly wiring 321 and/or the second assembly wiring 322 connected to the connection electrode 330 may be used as the first electrode wiring, and the electrode wiring 360 may be the second electrode wiring.

In other embodiments, a display device as described above may be a display panel, i.e., in embodiments, a display device and a display panel may be understood interchangeably. In embodiments, a display device in a practical sense may include a display panel and a controller (or processor) capable of controlling the display panel to display an image.

The above detailed description is not to be construed as limiting in any respect and should be considered exemplary. The scope of the embodiments should be determined by a reasonable interpretation of the appended claims, and all changes within the scope of the equivalents of the embodiments are included in the scope of the embodiments.

### [Industrial Availability]

Embodiments may be employed in a display field that displays images or information. The embodiments may be employed in a display field that displays images or information using a semiconductor light emitting device. The semiconductor light-emitting device may be a micro-scale semiconductor light-emitting device or a nano-scale semiconductor light-emitting device.

For example, embodiments may be employed in TVs, signage, smartphones, mobile phones, mobile terminals, automotive HUDs, backlight units for laptops, and display devices for VR or AR.

## Claims

1. A display device comprising:
a substrate including a plurality of subpixels;
a first assembly wiring provided in each of the plurality of subpixels;
a second assembly wiring provided in each of the plurality of subpixels;
a partition wall having an assembly hole on the first assembly wiring and the second assembly wiring; and
a semiconductor light emitting device in the assembly hole,
wherein the first assembly wiring comprises a first bus line; and a first assembly electrode on the first bus line,
wherein a portion of the first bus line is disposed adjacent to the assembly hole, and
wherein a portion of the first assembly electrode is disposed in the assembly hole.

2. The display device of claim 1, wherein the first assembly electrode is configured to surround the first bus line.

3. The display device of claim 1, wherein the first assembly wiring comprising:
a first extending line extending from the first bus line toward the assembly hole; and
a first extending electrode extending from the first assembly electrode toward the assembly hole.

4. The display device of claim 3, wherein the first extending line is not vertically overlapped with the assembly hole, and
wherein the first extending line is configured to vertically overlap the assembly hole.

5. The display device of claim 3, wherein a width of the first assembly electrode is greater than that of the first bus line,
wherein a width of the first extending electrode along a first direction is greater than a width of the first extending line, and
wherein a width of the first extending electrode along a second direction is less than that of the first extending line.

6. The display device of claim 1, wherein the second assembly wiring comprising;
a second bus line; and
a second assembly electrode on the second bus line,
wherein a portion of the second bus line is disposed adjacent to the assembly hole, and
wherein a portion of the second assembly electrode is disposed in the assembly hole.

7. The display device of claim 6, wherein the second assembly electrode is configured to surround the second bus line.

8. The display device of claim 6, wherein the second assembly wiring comprising;
a second extending line to extend from the second bus line toward the assembly hole; and
a second extending electrode to extend from the second assembly electrode toward the assembly hole.

9. The display device of claim 8, wherein the second extending line is not vertically overlapped with the assembly hole, and
wherein the second extending electrode is vertically overlapped with the assembly hole.

10. The display device of claim 8, wherein a width of the second assembly electrode is greater than that of the second bus line,
a width of the second extending electrode along the first direction is greater than that of the second extending line,
a width of the second extending electrode along the second direction is less than that of the second extending line.

11. The display device of claim 8, wherein the first extending electrode comprises at least two electrodes extending from the first assembly electrode.

12. The display device of claim 8, wherein the second extending electrode comprises at least two electrodes extending from the second assembly electrode.

13. The display device of claim 8, wherein the first extending electrode and the second extending electrode have a symmetrical structure with respect to each other.

14. The display device of claim 8, wherein the first extending electrode and the second extending electrode have an asymmetrical structure with respect to each other.

15. The display device of claim 6, wherein the first bus line and the second bus line are each disposed across the plurality of subpixels,
wherein the assembly electrode is electrically connected to the first bus line at each of the plurality of sub-pixels, and
wherein the second assembly electrode is electrically connected to the second bus line at each of the plurality of subpixels.

16. The display device of claim 6, wherein a thickness of the first assembly electrode is less than that of the first bus line, and
wherein a thickness of the second assembly electrode is less than that of the second bus line.

17. The display device of claim 1, further comprising a connection electrode connected to a side portion of the semiconductor light emitting device; and
an electrode wiring connected to an upper side of the semiconductor light emitting device,
wherein the connecting electrode is connected to at least one of the first assembly wiring or the second assembly wiring.
